(19) **Europäisches Patentamt / European Patent Office / Office européen des brevets**

(11) **EP 1 840 945 B1**

(12) **EUROPEAN PATENT SPECIFICATION**

(45) Date of publication and mention
of the grant of the patent:
**05.10.2016 Bulletin 2016/40**

(21) Application number: **06711853.9**

(22) Date of filing: **18.01.2006**

(51) Int Cl.:
***G03F 7/20*** (2006.01)

(86) International application number:
**PCT/JP2006/300584**

(87) International publication number:
**WO 2006/077849 (27.07.2006 Gazette 2006/30)**

(54) **LIGHTING OPTICAL DEVICE, EXPOSURE SYSTEM, AND EXPOSURE METHOD**

OPTISCHE BELEUCHTUNGSVORRICHTUNG, BELICHTUNGSSYSTEM UND BELICHTUNGSVERFAHREN

DISPOSITIF OPTIQUE D'ECLAIRAGE. SYSTEME D'EXPOSITION ET PROCEDE D'EXPOSITION

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **21.01.2005 JP 2005013576**
**19.04.2005 JP 2005120709**

(43) Date of publication of application:
**03.10.2007 Bulletin 2007/40**

(60) Divisional application:
**16185285.0**

(73) Proprietor: **Nikon Corporation**
**Tokyo 108-6290 (JP)**

(72) Inventors:
• **TANITSU, Osamu**
**Chiyoda-ku, Tokyo 100-8331 (JP)**

• **HIROTA, Hiroyuki**
**Chiyoda-ku, Tokyo 100-8331 (JP)**
• **SHIGEMATSU, Koji**
**Chiyoda-ku, Tokyo 100-8331 (JP)**
• **KURITA, Shinichi**
**Chiyoda-ku, Tokyo 100-8331 (JP)**

(74) Representative: **Hoffmann Eitle**
**Patent- und Rechtsanwälte PartmbB**
**Arabellastraße 30**
**81925 München (DE)**

(56) References cited:
**EP-A- 1 260 849** **WO-A-2005/031467**
**WO-A1-2004/051717** **JP-A- 06 188 169**
**JP-A- 06 244 082** **JP-A- 07 201 723**
**JP-A- 2003 532 281** **JP-A- 2004 087 987**
**JP-A- 2005 236 088** **JP-A- 2006 019 702**
**US-A- 5 459 000** **US-A- 5 933 219**
**US-A1- 2001 035 942**

## Description

Technical Field

The present invention relates to an adjustment method of illumination optical apparatus, an illumination optical apparatus, an exposure apparatus, and an exposure method and, more particularly, an illumination optical apparatus suitably applicable to exposure apparatus and others used for manufacturing microdevices, such as semiconductor devices, image pickup devices, liquid-crystal display devices, and thin-film magnetic heads, by lithography.

Background Art

In the typical exposure apparatus of this type, a light beam emitted from a light source is guided through a fly's eye lens (or microlens array or the like) as an optical integrator to form a secondary light source as a substantive surface illuminant consisting of a lot of light sources. Light beams from the secondary light source are condensed by a condenser lens and thereafter illuminate a mask with a predetermined pattern therein, in a superposed manner.

Light transmitted by the pattern of the mask travels through a projection optical system to be focused on a wafer. In this manner the mask pattern is projected (or transferred) onto the wafer to effect exposure thereof. The pattern formed in the mask is of high integration and a uniform illuminance distribution must be formed on the wafer in order to accurately transfer this microscopic pattern onto the wafer. The exposure light sources presently used include a KrF excimer laser light source for supplying light at the wavelength of 248 nm, an ArF excimer laser light source for supplying light at the wavelength of 193 nm, and so on.

In the conventional exposure apparatus, the mask is illuminated while the light supplied from the light source of this kind is converted into linearly polarized light with a desired polarization direction by a wave plate in accordance with the mask pattern (e.g., cf. Patent Document 1). Specifically, in the case of the conventional exposure apparatus described in Patent Document 1, a quarter-wave plate and a half-wave plate made of rock crystal are disposed in an optical path between the light source and a diffractive optical element (light beam converting element).

Patent Document 1: International Publication No. WO2004/051717

Disclosure of the Invention

Problem to be Solved by the Invention

It is, however, difficult to accurately produce a wave plate such as the quarter-wave plate or half-wave plate from a single rock crystal plate. When the wave plate fails to accurately function because of manufacturing error, the mask (and the wafer eventually) cannot be illuminated with desired linearly polarized light and this will result in failing to perform good exposure in a desired illumination condition according to the mask pattern.

The present invention has been accomplished in view of the foregoing problem and an object of the invention is to provide an illumination optical apparatus capable of illuminating a surface to be illuminated, with light in a desired polarization state, without substantive influence of manufacturing error of an optical member functioning as a wave plate. Another object of the present invention is to provide an exposure apparatus and exposure method capable of performing good exposure under an appropriate illumination condition, using the illumination optical apparatus for illuminating a mask set on the surface to be illuminated, with light in a desired polarization state. Document EP 1 260 849 A1 discloses an illumination optical system having the features of the preamble portion of claim 1. Likewise, document US 5,933,219 A discloses an illumination optical system having the features of the preamble portion of claim 2.

Means for Solving the Problem

In order to solve the above problem, a first aspect of the present invention provides an illumination optical system for illuminating a surface to be illuminated, in a desired polarization state on the basis of light from a light source, according to claim 1.

Said illumination optical system comprises a polarization converting element located on or near an illumination pupil plane and adapted for converting a polarization state of incident light into a predetermined polarization state, wherein the polarization converting element is adapted to locally change a polarization state of light at a position on or near the pupil plane of the illumination optical system, and characterized in that the polarization converting element has a plurality of variable optical rotating members for variably yielding a polarization rotation angle to incident linearly polarized light.

A second aspect of the present invention provides an illumination optical system for illuminating a surface to be illuminated, according to claim 2.

Said illumination optical system comprises a polarization converting element located near the surface to be illuminated, at a position optically conjugate with the surface to be illuminated, or near the conjugate position and adapted for converting a polarization state of incident light into a predetermined polarization state,
wherein the polarization converting element is adapted to locally change a polarization state of illumination light on the surface to be illuminated, and
characterized in that the polarization converting element has a plurality of variable optical rotating members for variably yielding a polarization rotation angle to incident linearly polarized light.

A third aspect of the present invention provides an exposure apparatus according to claim 23. Said exposure apparatus comprises the illumination optical system as defined in the aspects above, adapted to project a predetermined pattern illuminated by the illumination optical system onto a photosensitive substrate as the surface to be illuminated to effect exposure thereof.

A fourth aspect of the present invention provides a method of manufacturing device according to claim 24. Said method of manufacturing device comprises:

an exposure step of projecting a predetermined pattern onto a photosensitive substrate to effect exposure thereof, using the exposure apparatus as defined in claim 22; and
a development step of developing the photosensitive substrate exposed in the exposure step.

Further advantageous embodiments are defined in the respective dependent claims.

Effect of the Invention

In one aspect of the present invention, a local polarization state is variable on the pupil plane and, therefore, an optimal illumination condition can be established, for example, in a case where a pattern on the surface to be illuminated is illuminated to effect exposure thereof on the photosensitive substrate. In another aspect of the present invention, a local polarization state is variable on the surface to be illuminated and, therefore, an in-plane difference between pattern transfer states can be reduced, for example, in a case where a pattern placed on the surface to be illuminated is illuminated to effect exposure thereof on the photosensitive substrate.

In still another aspect of the present invention, since the variable phase difference member for variably yielding a phase difference between incident light and emerging light, for example, like a Soleil compensator or a Babinet compensator is used as an optical member functioning as a wave plate, different from the conventional technology of manufacturing the wave plate such as the quarter-wave plate or the half-wave plate from a single rock crystal plate, it can be used after adjusted so as to accurately function, for example, as a quarter-wave plate or a half-wave plate even when an optical element constituting the variable phase difference member has some manufacturing error.

Therefore, the illumination optical apparatus of the present invention is able to illuminate the mask as a surface to be illuminated, with light in a desired polarization state, without substantive influence of manufacturing error of each optical element forming an optical member functioning as a wave plate. As a result, the exposure apparatus and exposure method of the present invention are able to perform good exposure under an appropriate illumination condition, using the illumination optical apparatus for illuminating a pattern set on the surface to be illuminated, with light in a desired polarization state, and, therefore, to manufacture a good microdevice.

Brief Description of the Drawings

Fig. 1 is a drawing schematically showing a configuration of an exposure apparatus according to an embodiment of the present invention.
Fig. 2 is a drawing schematically showing an internal configuration of a polarization state measuring section shown in Fig. 1.
Fig. 3 is a drawing schematically showing configurations for each of variable phase difference members according to the embodiment.
Fig. 4 is a drawing schematically showing a configuration of an exposure apparatus according to a first modification example.
Fig. 5 is a drawing schematically showing a configuration of a variable optical rotator unit according to the first modification example.
Fig. 6 is a drawing schematically showing a configuration of each variable optical rotating member forming the variable optical rotator unit shown in Fig. 5.
Fig. 7 is a drawing for explaining the optical rotatory power of rock crystal.

Fig. 8 is a drawing schematically showing an annular secondary light source set in a circumferential polarization state by action of the variable optical rotator unit shown in Fig. 5.

Fig. 9 is a drawing schematically showing an annular secondary light source set in a radial polarization state by action of the variable optical rotator unit shown in Fig. 5.

Fig. 10 is a drawing schematically showing a configuration of a variable phase difference unit according to the embodiment of the present invention.

Fig. 11 is a drawing for schematically explaining the action of the variable phase difference unit shown in Fig. 10.

Fig. 12 is a drawing schematically showing a configuration of another variable phase difference unit according to the embodiment of the present invention.

Fig. 13 is a drawing for schematically explaining the action of the variable phase difference unit shown in Fig. 12.

Fig. 14 is a drawing schematically showing a configuration of a variable optical rotator unit according to a second modification example.

Fig. 15 is a drawing schematically showing a configuration of a variable optical rotator unit according to a modification example of the example shown in Fig. 14.

Fig. 16 is a drawing schematically showing a configuration of a variable optical rotator/phase shifter unit according to a third modification example.

Fig. 17 includes (a) a drawing showing a multi-pole secondary light source and (b) a drawing showing a positional relation at an exit where light beams forming the multi-pole secondary light source shown in (a) are emitted from phase shifters of a variable phase shifter unit.

Fig. 18 is a drawing schematically showing a configuration and action of a pair of aspherical optical rotators according to a fourth modification example.

Fig. 19 is a drawing schematically showing an example of optical rotation (phase shift) distributions given to a pair of aspherical optical rotators (phase shifters).

Fig. 20 is a drawing schematically showing another example of optical rotation (phase shift) distributions given to a pair of aspherical optical rotators (phase shifters).

Fig. 21 is a drawing schematically showing a modification example using three aspherical optical rotators (phase shifters) having respective optical rotation (phase shift) distributions of optical rotations (phase shifts) differing according to incidence positions.

Fig. 22 is a drawing showing cross sections of an on-axis light beam and an off-axis light beam passing the aspherical optical rotators (phase shifters) in the modification example of Fig. 21.

Fig. 23 is a flowchart schematically showing steps in an adjustment method of illumination optical apparatus according to the embodiment of the present invention.

Fig. 24 is a flowchart schematically showing steps in an adjustment method according to a modification example of the embodiment.

Fig. 25 is a diagram expressing an overall system of the embodiment as a view from a certain aspect.

Fig. 26 is a conceptual diagram expressing an overall system of the embodiment as a view from another aspect different from Fig. 25.

Fig. 27 is a drawing showing an example of a user interface screen provided on a display in the system of Fig. 26.

Fig. 28 is a drawing schematically showing a configuration of an aspherical optical rotator (phase shifter) used for compensation for only a linear component (inclination component) in an optical rotation (phase shift) distribution.

Fig. 29 is a flowchart of a technique of manufacturing semiconductor devices as microdevices.

Fig. 30 is a flowchart of a technique of manufacturing a liquid-crystal display element as a microdevice.

Best Modes for Carrying out of the Invention

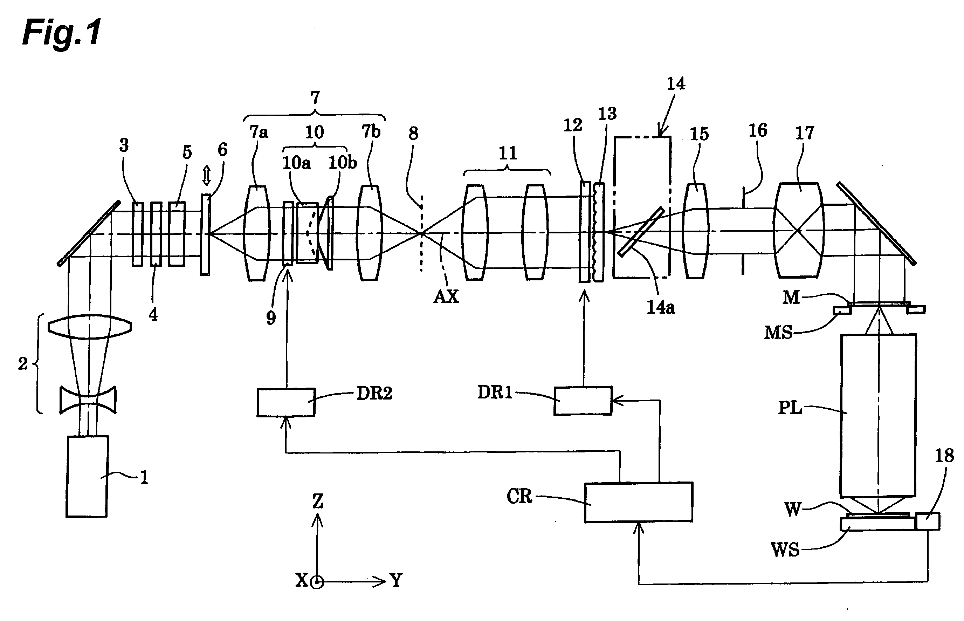

Embodiments of the present invention will be described based on the accompanying drawings. Fig. 1 is a drawing schematically showing a configuration of an exposure apparatus according to an embodiment of the present invention. In Fig. 1, the Z-axis is set along a direction of a normal to a wafer W being a photosensitive substrate, the Y-axis along a direction parallel to the plane of Fig. 1 in the plane of the wafer W, and the X-axis along a direction normal to the plane of Fig. 1 in the plane of the wafer W.

With reference to Fig. 1, the exposure apparatus of the present embodiment is provided with a light source 1 for supplying exposure light (illumination light). The light source 1 used herein can be, for example, an ArF excimer laser light source for supplying light of wavelength of 193 nm, a KrF excimer laser light source for supplying light of wavelength of 248 nm, or the like. Light emitted from the light source 1 is expanded into a light beam of a required cross-sectional shape by a shaping optical system 2, and travels via a first variable phase difference member 3 functioning as a quarter-wave plate, a second variable phase difference member 4 functioning as a half-wave plate, a depolarizer (depolarizing element) 5, and a diffractive optical element 6 for annular illumination, to enter an afocal lens 7.

The first variable phase difference member 3, second variable phase difference member 4, and depolarizer 5 constitute a polarization state switch as described later, configurations and actions of which will be described later. The afocal lens 7 is an afocal system (afocal optical system) set so that a front focal position of a front lens unit 7a is approximately coincident with a position of the diffractive optical element 6 and so that a rear focal position of a rear lens unit 7b is approximately coincident with a position of a predetermined plane 8 indicated by a dashed line in the drawing. In general, a diffractive optical element is made by forming steps at a pitch approximately equal to the wavelength of the exposure light (illumination light) in a substrate, and functions to diffract an incident light beam at desired angles.

Specifically, the diffractive optical element 6 for annular illumination has a function of forming a light intensity distribution of an annular shape in its far field (Fraunhofer diffraction region) when a parallel light beam having a rectangular cross section is incident thereto. Therefore, a nearly parallel light beam incident to the diffractive optical element 6 as a light beam converting element forms an annular light intensity distribution on the pupil plane of the afocal lens 7 and thereafter is outputted in an annular angle distribution from the afocal lens 7. A variable phase difference unit 9 and a conical axicon system 10 are disposed on or near the pupil plane in the optical path between the front lens unit 7a and the rear lens unit 7b of the afocal lens 7. Configurations and actions of the variable phase difference unit 9 and the conical axicon system 10 will be described later.

The light beam having passed through the afocal lens 7 travels through a zoom lens 11 for variation of σ-value (σ-value = mask-side numerical aperture of illumination optical apparatus/mask-side numerical aperture of projection optical system) and through a variable optical rotator unit (a variable polarization rotating unit) 12 to enter a micro fly's eye lens (or fly's eye lens) 13. A configuration and action of the variable optical rotator unit 12 will be described later. The micro fly's eye lens 13 is an optical element consisting of a lot of microscopic lenses with a positive refractive power arranged vertically and horizontally and densely. In general, a micro fly's eye lens is composed of a microscopic lens group which is made, for example, by etching a plane-parallel plate.

It is noted herein that each microscopic lens forming the micro fly's eye lens is smaller than each lens element forming a fly's eye lens. The micro fly's eye lens is one in which a lot of microscopic lenses (microscopic refracting surfaces) are integrally formed without being isolated from each other, different from the fly's eye lens consisting of lens elements isolated from each other. However, the micro fly's eye lens is also an optical integrator of the same wavefront splitting type as the fly's eye lens in terms of the vertical and horizontal arrangement of the lens elements with the positive refractive power.

The position of the predetermined plane 8 is defined near the front focal position of the zoom lens 11 and the entrance surface of the micro fly's eye lens 13 is defined near the rear focal position of the zoom lens 11. In other words, the zoom lens 11 keeps the predetermined plane 8 and the entrance surface of the micro fly's eye lens 13 substantially in the relation of Fourier transform and, in turn, keeps the pupil plane of the afocal lens 7 nearly optically conjugate with the entrance surface of the micro fly's eye lens 13. The variable optical rotator unit 12 is located immediately before the micro fly's eye lens 13 and is arranged to be approximately optically conjugate with the pupil plane of the afocal lens 7 eventually.

Therefore, for example, an illumination field of an annular shape around the optical axis AX, similar to that on the pupil plane of the afocal lens 7, is formed on the entrance surface of the micro fly's eye lens 13. The entire shape of this annular illumination field similarly varies depending upon the focal length of the zoom lens 11. Each microscopic lens forming the micro fly's eye lens 13 has a rectangular cross section similar to a shape of an illumination field to be formed on a mask M (eventually, a shape of an exposure region to be formed on a wafer W).

The light beam incident to the micro fly's eye lens 13 is two-dimensionally split by a lot of microscopic lenses to form a secondary light source having a light intensity distribution approximately equal to the illumination field formed by the incident light beam, i.e., a secondary light source of a substantive surface illuminant of an annular shape centered around the optical axis AX, on or near the rear focal plane of the micro fly's eye lens 13 (eventually, the illumination pupil). Light beams from the secondary light source formed on or near the rear focal plane of the micro fly's eye lens 13 travel through a beam splitter 14a and a condenser optical system 15 to illuminate a mask blind 16 in a superposed manner. A configuration and action of a polarization monitor 14 incorporating the beam splitter 14a will be described later.

In this manner, an illumination field of a rectangular shape according to the shape and focal length of each microscopic lens forming the micro fly's eye lens 13 is formed on the mask blind 16 as an illumination field stop. The light beams having passed through an aperture (light transmitting part) of a rectangular shape in the mask blind 16 are subjected to focusing action of an imaging optical system 17 and thereafter illuminate the mask M with a predetermined pattern therein, in a superposed manner. Namely, the imaging optical system 17 forms an image of the rectangular aperture of the mask blind 16 on the mask M.

A light beam having passed through the pattern of the mask M held on a mask stage MS then travels through a projection optical system PL to form an image of the mask pattern on the wafer (photosensitive substrate) W held on a wafer stage WS. While the wafer stage WS is two-dimensionally driven and controlled and, therefore, while the wafer W is two-dimensionally driven and controlled in the plane (XY plane) perpendicular to the optical axis AX of the projection optical system PL, one-shot exposure or scan exposure is effected to sequentially project the pattern of the mask M into each of exposure regions on the wafer W.

When a diffractive optical element for quadrupole illumination (not shown) is set in the illumination optical path, instead of the diffractive optical element 6 for annular illumination, it can effect quadrupole illumination. The diffractive optical element for quadrupole illumination has the following function: when a parallel light beam having a rectangular cross section is incident thereto, it forms a light intensity distribution of a quadrupole shape in its far field. Therefore, light beams having passed through the diffractive optical element for quadrupole illumination form an illumination field of a quadrupole shape consisting of four circular illumination fields around the optical axis AX, for example, on the entrance surface of the micro fly's eye lens 13. As a result, the secondary light source of the same quadrupole shape as the illumination field formed on the entrance surface is also formed on or near the rear focal plane of the micro fly's eye lens 13.

When a diffractive optical element for circular illumination (not shown) is set in the illumination optical path, instead of the diffractive optical element 6 for annular illumination, it can effect normal circular illumination. The diffractive optical element for circular illumination has the following function: when a parallel light beam having a rectangular cross section is incident thereto, it forms a light intensity distribution of a circular shape in its far field. Therefore, a light beam having passed through the diffractive optical element for circular illumination forms an illumination field of a circular shape centered around the optical axis AX, for example, on the entrance surface of the micro fly's eye lens 13. As a result, the secondary light source of the same circular shape as the illumination field formed on the entrance surface is also formed on or near the rear focal plane of the micro fly's eye lens 13.

Furthermore, when another diffractive optical element for multi-pole illumination (not shown) is set in the illumination optical path, instead of the diffractive optical element 6 for annular illumination, it is feasible to implement one of various multi-pole illuminations (dipole illumination, octupole illumination, etc.). Similarly, when a diffractive optical element with an appropriate characteristic (not shown) is set in the illumination optical path, instead of the diffractive optical element 6 for annular illumination, it is feasible to implement one of off-axis or modified illuminations of various forms.

The conical axicon system 10 is composed of a first prism member 10a a plane of which faces the light source side and a refracting surface of a concave conical shape of which faces the mask side, and a second prism member 10b a plane of which faces the mask side and a refracting surface of a convex conical shape of which faces the light source side, in order from the light source side. Then the refracting surface of the concave conical shape of the first prism member 10a and the refracting surface of the convex conical shape of the second prism member 10b are formed in such complementary shapes as to be able to butt each other. At least one of the first prism member 10a and the second prism member 10b is arranged to be movable along the optical axis AX to vary the distance between the refracting surface of the concave conical shape of the first prism member 10a and the refracting surface of the convex conical shape of the second prism member 10b. The action of the conical axicon system 10 and the action of the zoom lens 11 will be described below with focus on the secondary light source of the annular shape or the quadrupole shape.

In a state in which the refracting surface of the concave conical shape of the first prism member 10a butts on the refracting surface of the convex conical shape of the second prism member 10b, the conical axicon system 10 functions as a plane-parallel plate and has no effect on the secondary light source of the annular shape or quadrupole shape formed. However, when the refracting surface of the concave conical shape of the first prism member 10a is located apart from the refracting surface of the convex conical shape of the second prism member 10b, the outside diameter (inside diameter) of the secondary light source of the annular shape or quadrupole shape varies while keeping constant the width of the secondary light source of the annular shape or quadrupole shape (half of a difference between the outside diameter and the inside diameter of the annular secondary light source; half of a difference between a diameter (outside diameter) of a circle circumscribed to the secondary light source of quadrupole shape and a diameter (inside diameter) of a circle inscribed to the secondary light source). Namely, the annular ratio (inside diameter/outside diameter) and the size (outside diameter) of the secondary light source of the annular shape or quadrupole shape vary.

The zoom lens 11 has a function of similarly enlarging or reducing the entire shape of the secondary light source of the annular shape or quadrupole shape. For example, when the focal length of the zoom lens 11 is increased from a minimum to a predetermined value, the entire shape of the secondary light source of the annular shape or quadrupole shape is similarly enlarged. In other words, the width and size (outside diameter) of the secondary light source both vary, without change in the annular ratio of the secondary light source of the annular shape or quadrupole shape, through the action of the zoom lens 11. In this manner, the annular ratio and size (outside diameter) of the secondary light source of the annular shape or quadrupole shape can be controlled by the actions of the conical axicon system 10 and the zoom lens 11.

The polarization monitor 14 is provided with the beam splitter 14a disposed in the optical path between the micro fly's eye lens 13 and the condenser optical system 15, and has a function of detecting a polarization state of incident light to this beam splitter 14a. In other words, whether the illumination light to the mask M (i.e., the wafer W eventually) is in a desired polarization state (which is a concept including an unpolarized state) is detected on an as-needed basis, based on the detection result by the polarization monitor 14.

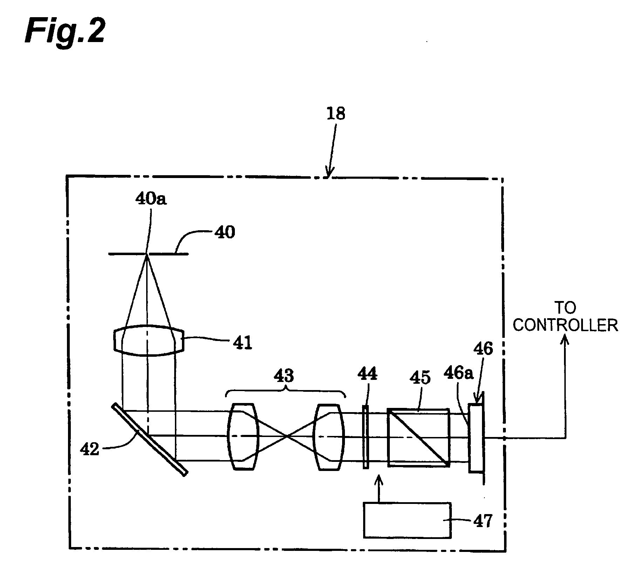

Fig. 2 is a drawing schematically showing an internal configuration of a polarization state measuring section in Fig. 1. In the present embodiment, as shown in Fig. 2, the wafer stage WS for holding the wafer W is provided with the polarization state measuring section 18 for measuring the polarization state of illumination light (exposure light) for the wafer W. The polarization state measuring section 18 has a pinhole member 40 that can be two-dimensionally located on a level with the exposed surface of the wafer W. The wafer W is retracted from the optical path during use of the polarization state measuring section 18.

Light having passed through a pinhole 40a of the pinhole member 40 travels through a collimating lens 41 to become a nearly parallel light beam and the nearly parallel light beam is reflected by a reflecting mirror 42 to enter a relay lens system 43. The nearly parallel light beam having passed through the relay lens system 43 then travels through a quarter-wave plate 44 as a phase shifter and through a polarization beam splitter 45 as a polarizer and thereafter reaches a detective surface 46a of two-dimensional CCD 46. An output from the two-dimensional CCD 46 is supplied to a controller (not shown). The quarter-wave plate 44 is arranged to be rotatable around the optical axis, and a setter 47 for setting an angle of rotation around the optical axis is connected to the quarter-wave plate 44.

When the degree of polarization of the illumination light for the wafer W is not 0 in this configuration, the quarter-wave plate 44 is rotated around the optical axis via the setter 47 so as to vary a light intensity distribution on the detective surface 46a of the two-dimensional CCD 46. Therefore, the polarization state measuring section 18 detects the variation in the light intensity distribution on the detective surface 46a while rotating the quarter-wave plate 44 around the optical axis by means of the setter 47, and is thus able to measure a polarization state (degree of polarization; the Stokes parameters $S_1$, $S_2$, $S_3$ about light) of the illumination light from the detection result by the rotating compensator method.

The rotating compensator method is described in detail, for example, in Tsuruta, "Pencil of Light:Applied Optics for Optical Engineers," K.K. Shingijutsu Communications. Practically, while the pinhole member 40 (therefore, the pinhole 40a) is two-dimensionally moved along the wafer surface, the polarization state of the illumination light is measured at a plurality of positions in the wafer surface. At this time, the polarization state measuring section 18 detects a variation in the light intensity distribution on the two-dimensional detective surface 46a, and it is thus feasible to measure a distribution of polarization states in the pupil of the illumination light on the basis of the detected distribution information.

Incidentally, the polarization state measuring section 18 can also use a half-wave plate as a phase shifter instead of the quarter-wave plate 44. Whatever phase shifter is used, it is necessary to detect the variation in the light intensity distribution on the detective surface 46a in at least four different states, for example, by changing the relative angle around the optical axis between the phase shifter and the polarizer (polarization beam splitter 45) or by retracting the phase shifter or the polarizer from the optical path, in order to measure the polarization state of light, i.e., the four Stokes parameters of light.

The present embodiment is arranged to rotate the quarter-wave plate 44 as a phase shifter around the optical axis, but it is also possible to adopt a configuration wherein the polarization beam splitter 45 as a polarizer is rotated around the optical axis, or a configuration wherein the phase shifter and the polarizer both are rotated around the optical axis. Instead of this operation, or in addition to this operation, one or both of the quarter-wave plate 44 as a phase shifter and the polarization beam splitter 45 as a polarizer may be inserted in and/or retracted from the optical path.

In the polarization state measuring section 18, the polarization characteristic of the reflecting mirror 42 can change the polarization state of light. In this case, since the polarization characteristic of the reflecting mirror 42 is preliminarily known, the measurement result by the polarization state measuring section 18 is compensated for based on the effect of the polarization characteristic of the reflecting mirror 42 on the polarization state by necessary calculation, whereby the polarization state of the illumination light can be accurately measured. In any case where the polarization state varies because of any other optical component, e.g., a lens, than the reflecting mirror, the measurement result can also be compensated for in the same manner and the polarization state of illumination light can be accurately measured.

As described above, the polarization state measuring section 18 is used to measure the polarization state (degree of polarization) in the pupil of the illumination light for the wafer W and to determine whether the illumination light is in an appropriate polarization state in the pupil. The above-described embodiment showed the configuration wherein the polarization state measuring section 18 could be attached to the wafer stage WS, but this polarization state measuring section 18 may be assembled into the wafer stage WS, or may be assembled into another stage different from the wafer stage WS.

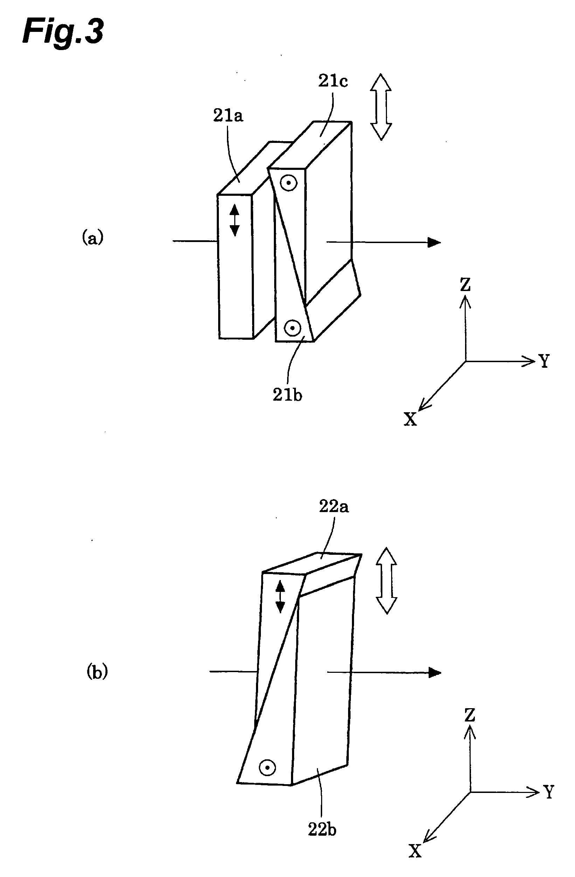

Fig. 3 is a drawing schematically showing configurations for each of the variable phase difference members according to the present embodiment. In the present embodiment, each of the first variable phase difference member 3 and the second variable phase difference member 4 is constructed as a Soleil compensator shown in Fig. 3 (a), or as a Babinet compensator shown in Fig. 3 (b). The Soleil compensator shown in Fig. 3 (a) is composed of a plane-parallel plate 21a, and a pair of deviation prisms 21 b and 21 c in order from the entrance side of light.

Here the plane-parallel plate 21a, first deviation prism 21b, and second deviation prism 21c are made of rock crystal as a birefringent crystal material. The first deviation prism 21b and the second deviation prism 21c have their respective wedge sectional shapes supplementary (complementary) to each other. Furthermore, the crystallographic axis of the plane-parallel plate 21 a is set to be perpendicular to the crystallographic axes of the pair of deviation prisms 21b and 21c.

A driving means (not shown), e.g., a micrometer head is arranged to move the first deviation prism 21b and the second deviation prism 21c relative to each other along the Z-direction, or to move the first deviation prism 21 b and the second deviation prism 21 c relative to each other along a line of intersection between the opposed slopes thereof and the YZ plane. The Soleil compensator (21a-21c) shown in Fig. 3 (a) variably yields a constant phase difference between incident light and emerging light according to the relative positions of the first deviation prism 21b and the second deviation prism 21c, without dependence on the incidence position of light.

On the other hand, the Babinet compensator shown in Fig. 3 (b) is composed of a first deviation prism 22a and a second deviation prism 22b in order from the entrance side of light. Here the first deviation prism 22a and the second deviation prism 22b are made of rock crystal as a birefringent crystal material and have their respective wedge sectional shapes complementary to each other. Furthermore, the crystallographic axis of the first deviation prism 22a is set to be perpendicular to the crystallographic axis of the second deviation prism 22b.

A driving means (not shown), e.g., a micrometer head is arranged to move the first deviation prism 22a and the second deviation prism 22b relative to each other along the Z-direction, or to move the first deviation prism 22a and the second deviation prism 22b relative to each other along a line of intersection between the opposed slopes and the YZ plane. The Babinet compensator (22a, 22b) shown in Fig. 3 (b) variably yields a substantially constant phase difference between incident light and emerging light according to the relative positions of the first deviation prism 22a and the second deviation prism 22b though it is somewhat dependent upon the incidence position of light along the Z-direction.

The present embodiment adopts the following preliminary adjustment: before mounted on the exposure apparatus, the first variable phase difference member 3 is singly checked to measure the phase difference yielded between incident light and emerging light, and is adjusted so that the phase difference is equal to a quarter of the wavelength $\lambda$ of light, i.e., so that the first variable phase difference member 3 can accurately function as a quarter-wave plate. Similarly, before mounted on the exposure apparatus, the second variable phase difference member 4 is singly checked to measure the phase difference yielded between incident light and emerging light, and is preliminarily adjusted so that the phase difference is equal to a half of the wavelength $\lambda$ of light, i.e., so that the second variable phase difference member 4 can accurately function as a half-wave plate.

Then the first variable phase difference member 3 adjusted so as to accurately function as a quarter-wave plate and the second variable phase difference member 4 adjusted so as to accurately function as a half-wave plate each are positioned at their respective predetermined locations in the optical path between the shaping optical system 2 and the depolarizer 5 and are set so as to be integrally rotatable around the optical axis AX. In this manner, the first variable phase difference member 3 as a quarter-wave plate is rotatably arranged around the optical axis AX and converts incident elliptically polarized light into linearly polarized light. The second variable phase difference member 4 as a half-wave plate is rotatably arranged around the optical axis AX and changes the polarization direction of incident linearly polarized light.

On the other hand, the depolarizer 5 is constructed as an integral prism assembly of a rock crystal deviation prism and a fluorite deviation prism (or silica deviation prism) of wedge shapes complementary to each other, which are not shown in the drawing, and is set to be retractable from the illumination optical path. Concerning the detailed configuration and action of the depolarizer 5, reference can be made, for example, to International Publication No. WO2004/051717.

When the light source 1 used is the KrF excimer laser light source or the ArF excimer laser light source, the light emitted from these light sources typically has the polarization degree of 95% or more, and nearly linearly polarized light is incident to the first variable phase difference member 3. However, when a right-angle prism as a back reflector is interposed in the optical path between the light source 1 and the first variable phase difference member 3, the linearly polarized light is converted into elliptically polarized light by virtue of total reflection in the right-angle prism unless the plane of polarization of incident linearly polarized light agrees with the p-polarization plane or s-polarization plane.

In the polarization switch (3-5), for example, where elliptically polarized light is incident by virtue of total reflection in the right-angle prism, the incident light of elliptic polarization is converted into linearly polarized light and the linearly polarized light is guided to the second variable phase difference member 4, by setting the first variable phase difference member 3 as a quarter-wave plate at a predetermined angular position around the optical axis AX with respect to the incident elliptically polarized light. Furthermore, the second variable phase difference member 4 as a half-wave plate is set at a required angular position around the optical axis AX with respect to the incident linearly polarized light, whereby the incident light of linear polarization is converted into linearly polarized light having the polarization direction along a desired direction and it is guided to the depolarizer 5, or directly to the diffractive optical element 6.

When the depolarizer 5 is inserted in the illumination optical path and when the depolarizer 5 is set at a predetermined angular position around the optical axis AX with respect to the incident linearly polarized light, the incident light of linear polarization is converted into light in an unpolarized state (or depolarized) to enter the diffractive optical element 6. On the other hand, when the depolarizer 5 is retracted from the illumination optical path, the linearly polarized light from the second variable phase difference member 4 is incident directly to the diffractive optical element 6, without change in the polarization direction.

When the polarization state switch (3-5) is so arranged that the depolarizer 5 is retracted from the illumination optical path and that the first variable phase difference member 3 as a quarter-wave plate and the second variable phase difference member 4 as a half-wave plate each are set at the predetermined angular positions around the optical axis AX, linearly polarized light having the polarization direction along a desired direction can be made incident to the diffractive optical element 6. When the first variable phase difference member 3 as a quarter-wave plate and the second variable phase difference member 4 as a half-wave plate each are set at the predetermined angular positions around the optical axis AX and when the depolarizer 5 is inserted in the illumination optical path and set at the predetermined angular position around the optical axis AX, light in an unpolarized state can be made incident to the diffractive optical element 6.

In other words, the polarization state switch (3-5) is able to switch the polarization state of the incident light to the diffractive optical element 6 (eventually, the polarization state of the light to illuminate the mask M and the wafer W) between a linear polarization state and an unpolarized state. In the case of the linear polarization state, it is possible, for example, to switch between mutually orthogonal polarization states (between Z-directional polarization and X-directional polarization).

As described above, the present embodiment uses the variable phase difference members (3, 4) for variably yielding the phase difference between incident light and emerging light like the Soleil compensator and the Babinet compensator, as the optical members functioning as wave plates such as the quarter-wave plate and the half-wave plate, different from the conventional technology of producing the wave plate such as the quarter-wave plate or the half-wave plate from a single rock crystal plate. Therefore, even when there is some manufacturing error in the optical elements (plane-parallel plate and deviation prisms) constituting the variable phase difference members (3, 4), they can be used after adjusted each so as to accurately function as a quarter-wave plate and as a half-wave plate.

Therefore, the illumination optical apparatus (1-17) of the present embodiment is able to illuminate the mask M as a surface to be illuminated, with light in a desired polarization state, without substantive influence of manufacturing error of the optical elements (21a-21c; 22a, 22b) constituting the optical members (3, 4) functioning as wave plates. As a result, the exposure apparatus (1-WS) of the present embodiment is able to perform good exposure under an appropriate illumination condition, using the illumination optical apparatus (1-17) for illuminating the mask M set on the surface to be illuminated, with light in a desired polarization state.

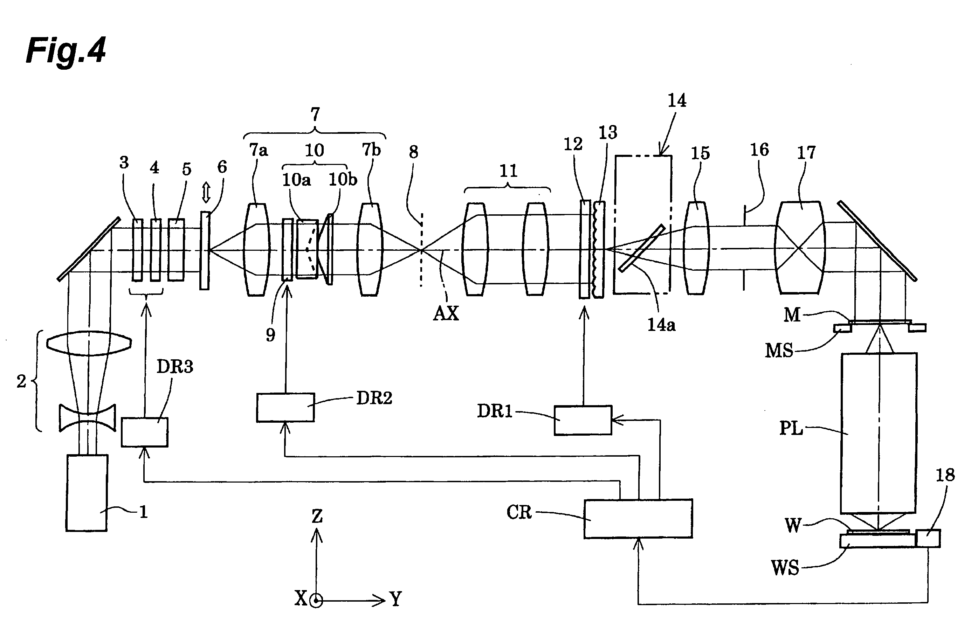

In the above description, the variable phase difference members (3, 4) are incorporated in the illumination optical path after each of them is singly preliminarily adjusted by measuring the phase difference and controlling the phase difference to the predetermined value (a quarter or half of the wavelength $\lambda$ of light). However, the present invention does not have to be limited to this configuration, but may adopt the following configuration, as shown in a modification example of Fig. 4: the variable phase difference members (3, 4) are incorporated in the illumination optical path and then the variable phase difference members (3, 4) each are adjusted so as to function accurately as a quarter-wave plate and as a half-wave plate, based on the measurement result by the polarization state measuring section 18. It is also possible to adopt a configuration wherein the variable phase difference members (3, 4) after adjusted to function accurately as a quarter-wave plate and as a half-wave plate are further positively finely adjusted so as to permit the mask M as a surface to be illuminated and thus the wafer W to be illuminated with light in a variety of polarization states.

In Fig. 4, a controller CR is arranged to receive the measurement result from the polarization state measuring section 18, to control the relative positions between the optical elements (21a-21c; 22a, 22b) in the variable phase difference members (3, 4), and to adjust the phase difference amounts by the variable phase difference members (3, 4) so that the polarization state on the mask M or on the wafer W as a surface to be illuminated becomes a desired state.

In the above description, each optical element forming the variable phase difference members (3, 4) is made of rock crystal, but, without having to be limited to this, each optical element in the variable phase difference members (3, 4) may be made of a birefringent crystal material, e.g., magnesium fluoride or calcite.

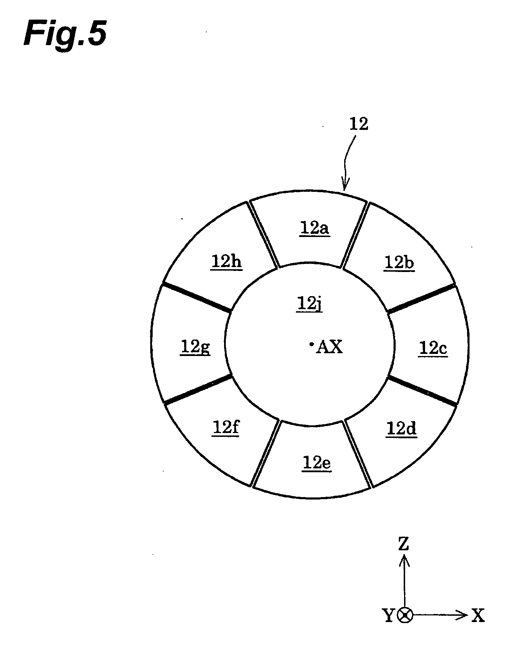

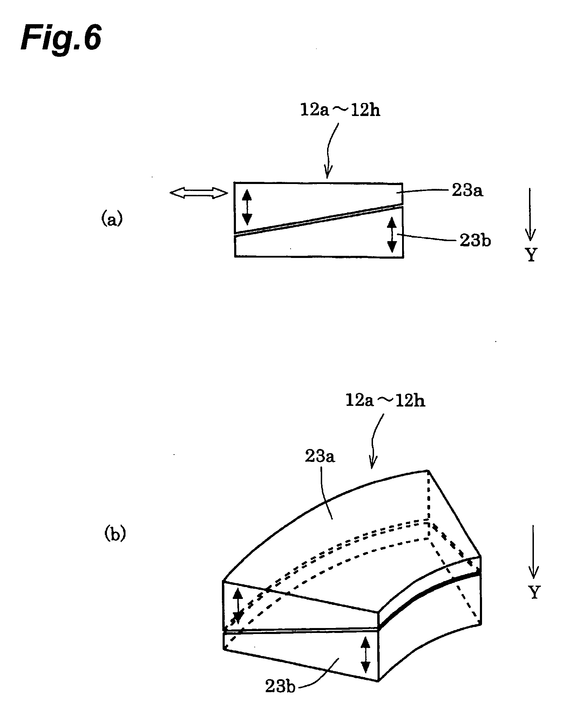

Fig. 5 is a drawing schematically showing a configuration of the variable optical rotator unit (the variable polarization rotating unit) according to the present embodiment. Fig. 6 is a drawing schematically showing a configuration of each variable optical rotating member forming the variable optical rotator unit shown in Fig. 5. The variable optical rotator unit 12 according to the present embodiment is located immediately before the micro fly's eye lens 13, i.e., on or near the pupil of the illumination optical system (2-17). Therefore, in the case of the annular illumination, a light beam having a nearly annular cross section around the optical axis AX is incident to the variable optical rotator unit 12.

With reference to Fig. 5, the variable optical rotator unit 12 is composed of eight variable optical rotating members 12a, 12b, 12c, 12d, 12e, 12f, 12g, and 12h arranged along a circumferential direction of a circle centered around the optical axis AX. Each variable optical rotating member 12a-12h has a contour of a sector shape obtained by equally dividing the annular region around the optical axis AX into eight circumferential segments, and they have the same fundamental configuration. With reference to Fig. 6, each variable optical rotating member 12a-12h is composed of a pair of deviation prisms 23a and 23b made of rock crystal as an optical material with optical activity (rotary polarization characteristic).

The first deviation prism 23a and the second deviation prism 23b have their respective wedge sectional shapes complementary to each other, and are arranged so that the crystallographic axis of the first deviation prism 23a and the crystallographic axis of the second deviation prism 23b both are parallel to the optical axis AX (i.e., parallel to the Y-direction). A driving means (not shown), e.g., a micrometer head is arranged to move the first deviation prism 23a and the second deviation prism 23b relative to each other along the radial direction of the circle centered around the optical axis AX, or to move the first deviation prism 23a and the second deviation prism 23b relative to each other along a line of intersection between their opposed slopes and the plane including the optical axis AX.

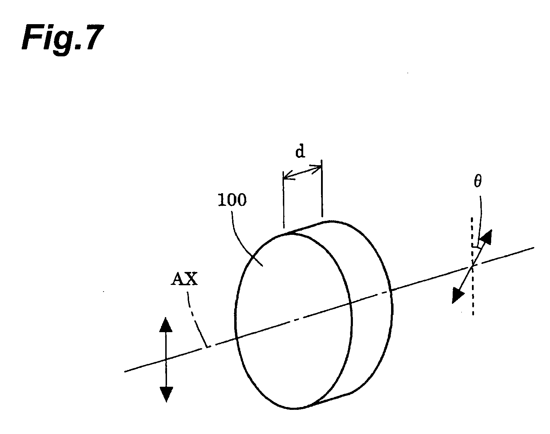

In this way, each variable optical rotating member 12a-12h shown in Fig. 6 variably yields a polarization rotation angle to incident linearly polarized light, according to the relative positions of the first deviation prism 23a and the second deviation prism 23b. The optical activity (rotary polarization characteristic) of rock crystal will be briefly described below with reference to Fig. 7. With reference to Fig. 7, an optical member 100 of a plane-parallel plate shape made of rock crystal and having the thickness d is located so that its crystallographic axis agrees with the optical axis AX. In this case, the optical member 100 rotates the polarization direction of incident linearly polarized light by $\theta$ around the optical axis AX and the emerging light is in the $\theta$-rotated state based on the optical activity of the optical member 100.

At this time, the angle of rotation of the polarization direction (polarization rotation angle) $\theta$ by the optical activity of the optical member 100 is expressed by Eq (a) below, using the thickness d of the optical member 100 and an optical rotatory power $\rho$ of rock crystal.

$$\theta = d \cdot \rho \qquad (a)$$

In general, the optical rotatory power $\rho$ of rock crystal has wavelength dependence (a property in which the value of optical rotatory power differs depending upon the wavelength of light used: optically rotating dispersion) and, specifically, it tends to increase with decrease in the wavelength of light used. According to the description on p167 in "Applied Optics II," the optical rotatory power $\rho$ of rock crystal for light with the wavelength of 250.3 nm is 153.9°/mm.

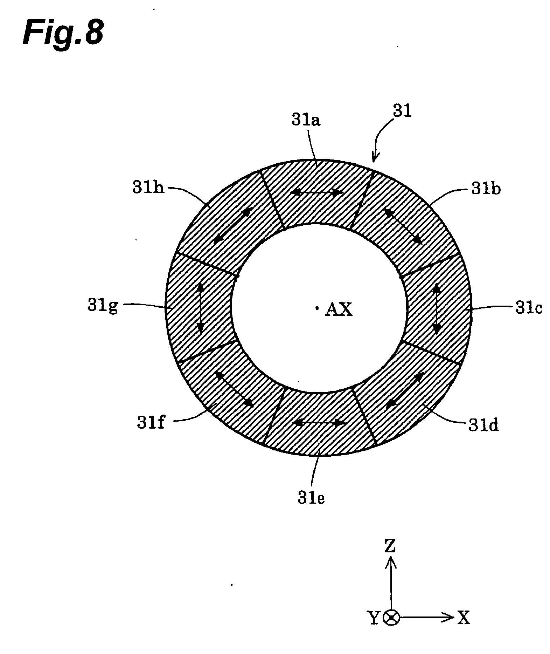

Fig. 8 is a drawing schematically showing a secondary light source of an annular shape set in a circumferential polarization (azimuthal polarization) state by the action of the variable optical rotator unit shown in Fig. 5. In the present embodiment, the variable optical rotating members 12a and 12e opposed with respect to the optical axis AX are arranged as follows: the relative positions of the first deviation prism 23a and the second deviation prism 23b are so set that when linearly polarized light having the polarization direction along the Z-direction is incident thereto, they output linearly polarized light having the polarization direction along a direction resulting from +90° rotation of the Z-direction around the Y-axis, i.e., along the X-direction. In this case, therefore, the polarization direction of light beams passing through a pair of sector regions (or arcuate regions) 31 a and 31e formed by light beams subject to the optical rotating action of the variable optical rotating members 12a and 12e, in the annular secondary light source 31 shown in Fig. 8, is the X-direction.

The variable optical rotating members 12b and 12f opposed with respect to the optical axis AX are arranged as follows: the relative positions of the first deviation prism 23 a and the second deviation prism 23b are so set that when linearly polarized light having the polarization direction along the Z-direction is incident thereto, they output linearly polarized light having the polarization direction along a direction resulting from +135° rotation of the Z-direction around the Y-axis, i.e., along a direction resulting from -45° rotation of the Z-direction around the Y-axis. In this case, therefore, the polarization direction of light beams passing through a pair of sector regions 31b and 31f formed by light beams subject to the optical rotating action of the variable optical rotating members 12b and 12f, in the annular secondary light source 31 shown in Fig. 8, is the direction resulting from -45° rotation of the Z-direction around the Y-axis.

The variable optical rotating members 12c and 12g opposed with respect to the optical axis AX are arranged as follows: the relative positions of the first deviation prism 23a and the second deviation prism 23b are so set that when linearly polarized light having the polarization direction along the Z-direction is incident thereto, they output linearly polarized light having the polarization direction along a direction resulting from +180° rotation of the Z-direction around the Y-axis, i.e., along the Z-direction. In this case, therefore, the polarization direction of light beams passing through a pair of sector regions 31 c and 31 g formed by light beams subject to the optical rotating action of the variable optical rotating members 12c and 12g, in the annular secondary light source 31 shown in Fig. 8, is the Z-direction.

The variable optical rotating members 12d and 12h opposed with respect to the optical axis AX are arranged as follows: the relative positions to the first deviation prism 23a and the second deviation prism 23b are so set that when linearly polarized light having the polarization direction along the Z-direction is incident thereto, they output linearly polarized light having the polarization direction along a direction resulting from +45° rotation of the Z-direction around the Y-axis. In this case, therefore, the polarization direction of light beams passing through a pair of sector regions 31d and 31h formed by light beams subject to the optical rotating action of the variable optical rotating members 12d and 12h, in the annular secondary light source 31 shown in Fig. 8, is the direction resulting from +45° rotation of the Z-direction around the Y-axis.

As described above, the variable optical rotator unit 12 constitutes a polarization converting element disposed on or near the illumination pupil plane and adapted for converting the polarization state of incident light into a predetermined polarization state. It is noted that the present embodiment is provided with a center region 12j of a circular shape having the size equal to 3/10 or more, preferably 1/3 or more, of the radial size of the effective region of the variable optical rotator unit 12 and having no optical rotatory power, in order to implement normal circular illumination without retracting the variable optical rotator unit 12 from the optical path. The center region 12j may be made of an optical material without optical rotatory power, e.g., silica and fluorite, or may be simply a circular aperture. It is, however, noted that the center region 12j is not an essential element to the variable optical rotator unit 12.

In the present embodiment, circumferential polarization (azimuthal polarization) annular illumination (off-axis illumination in which light beams passing through the annular secondary light source are set in a circumferential polarization state) is implemented by making linearly polarized light with the polarization direction along the Z-direction incident into the variable optical rotator unit 12 by the action of the polarization state switch (3-5). As a result, as shown in Fig. 8, the annular secondary light source (annular illumination pupil distribution) 31 is formed on or near the rear focal plane of the micro fly's eye lens 13, and light beams passing through this annular secondary light source 31 are set in the circumferential polarization state by the action of the variable optical rotator unit 12. In the circumferential polarization state, the light beams passing through the respective sector regions 31a-31h constituting the annular secondary light source 31 are in a linear polarization state with the polarization direction approximately coincident with a direction of a tangent to a circle centered around the optical axis AX, at the center position along the circumferential direction of each sector region 31a-31h.

In the present embodiment, as described above, the annular secondary light source (illumination pupil distribution) 31 in the circumferential polarization state can be formed, without substantive occurrence of loss in quantity of light, by the optical rotating action of the variable optical rotator unit 12. In the circumferential polarization annular illumination based on the annular illumination pupil distribution in the circumferential polarization state, the light projected onto the wafer W as a final surface to be illuminated is in a polarization state in which the principal component is s-polarized light. The s-polarized light is linearly polarized light having the polarization direction along a direction normal to the plane of incidence (polarized light whose electric vector vibrates in the direction normal to the plane of incidence). It is, however, noted that the plane of incidence is a plane defined as follows: when light arrives at a boundary surface of a medium (surface to be illuminated: a surface of wafer W), the plane includes a normal to the boundary surface at the arrival point and the direction of incidence of the light.

As a result, the circumferential polarization annular illumination improves the optical performance (depth of focus or the like) of the projection optical system PL and provides a high-contrast image of the mask pattern on the wafer (photosensitive substrate) W. Namely, since the exposure apparatus of the present embodiment uses the illumination optical apparatus capable of forming the annular illumination pupil distribution in the circumferential polarization state while well suppressing the loss in quantity of light, the microscopic pattern can be transferred accurately and at high throughput under an appropriate illumination condition.

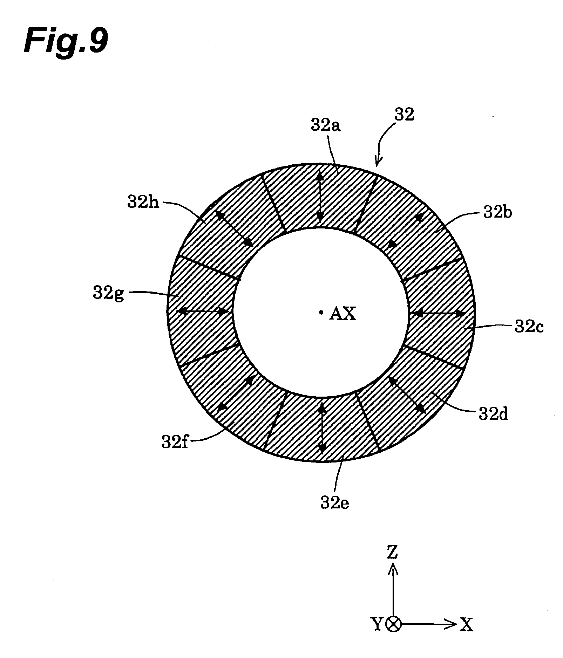

In the present embodiment, the apparatus is arranged to implement radial polarization annular illumination (off-axis illumination in which light beams passing through the annular secondary light source 32 are set in a radial polarization state), by making linearly polarized light with the polarization direction along the X-direction incident to the variable optical rotator unit 12 by the action of the polarization state switch (3-5) and by setting the light beams passing through the annular secondary light source 32 in the radial polarization state as shown in Fig. 9. In the radial polarization state, light beams passing through the respective sector regions 32a-32h constituting the annular secondary light source 32 are in a linear polarization state with the polarization direction approximately coincident with a radial direction of a circle centered around the optical axis AX, at the center position along the circumferential direction of each sector region 32a-32h.

In the radial polarization annular illumination based on the annular illumination pupil distribution in the radial polarization state, the light projected onto the wafer W as a final surface to be illuminated is in a polarization state in which the principal component is p-polarized light. The p-polarized light herein is linearly polarized light having the polarization direction along a direction parallel to the plane of incidence defined as described above (i.e., polarized light whose electric vector vibrates in the direction parallel to the plane of incidence). As a result, the radial polarization annular illumination enables the apparatus to obtain a good mask pattern image on the wafer (photosensitive substrate) while controlling the reflectance of light to a low level on a resist applied to the wafer W.

Incidentally, the Applicant of the present application proposed the following configuration, for example, in International Publication No. WO2005/076045: plural types of rock crystal plates having mutually different thicknesses along the transmission direction of light (lengths in the optical-axis direction) are arranged as optical rotating members in the circumferential direction, to form a polarization converting element disposed on or near the illumination pupil plane and adapted for converting the polarization state of incident light into a predetermined polarization state. In the case of the polarization converting element proposed in the above-described application, it is difficult to accurately produce each of the optical rotating members for yielding a required angle of rotation to incident linearly polarized light, from a single rock crystal plate. When each optical rotating member fails to accurately function because of manufacturing error, it is infeasible to implement the desired circumferential polarization state, radial polarization state, and so on.

In contrast to it, the present embodiment adopts the configuration wherein the variable optical rotator unit 12 as a polarization converting element is composed of the plurality of variable optical rotating members 12a-12h for variably yielding the angle of rotation to incident linearly polarized light according to the relative positions of the first deviation prism 23a and the second deviation prism 23b. Therefore, even when there is some manufacturing error in the optical elements (pair of deviation prisms) constituting each variable optical rotating member 12a-12h, the variable optical rotator unit 12 can be used after each variable optical rotating member 12a-12h is adjusted so as to function accurately as an optical member for yielding the required angle of rotation.

Specifically, before mounted on the exposure apparatus, an optical rotation angle by each variable optical rotating member 12a-12h is measured, each variable optical rotating member 12a-12h (eventually, the relative positions of the first deviation prism 23a and the second deviation prism 23b) is adjusted so that the optical rotation angle becomes a predetermined value, and then the variable optical rotator unit 12 is incorporated in the illumination optical path. Another potential configuration is such that the variable optical rotator unit 12 is first incorporated in the illumination optical path, and then the relative positions of the first deviation prism 23 a and the second deviation prism 23b each are adjusted so that each variable optical rotating member 12a-12h accurately functions, based on the measurement result by the polarization state measuring section 18. Still another potential configuration is such that each variable optical rotating member 12a-12h is further positively finely adjusted from a state in which it has been adjusted to function accurately as the variable optical rotator unit 12, whereby the mask and, therefore, the wafer W as a surface to be illuminated can be illuminated with light in a variety of polarization states (e.g., a modified circumferential polarization state slightly different from the perfect circumferential polarization state, or the like).

In this case, as shown in Fig. 1, the controller CR is arranged to receive the measurement result from the polarization state measuring section 18, to control a driver DR1 for changing the relative positions of the optical elements (12a-12h) in the variable optical rotator unit 12, and to adjust a distribution of optical rotation amounts by the variable optical rotator unit 12 so that the polarization state of light beams to the mask M or to the wafer W as a surface to be illuminated becomes a desired state.

In this manner, the illumination optical apparatus (1-17) of the present embodiment is able to illuminate the mask M as a surface to be illuminated, with light in a desired polarization state, without substantive influence of manufacturing error of each optical element (12a-12h; 23a, 23b) forming the variable optical rotator unit 12. As a result, the exposure apparatus (1-WS) of the present embodiment is able to perform good exposure under an appropriate illumination condition, using the illumination optical apparatus (1-17) for illuminating the mask M set on the surface to be illuminated, with light in the desired polarization state.

In the above description, the circumferential polarization annular illumination and the radial polarization annular illumination are implemented by switching the light beam incident to the variable optical rotator unit 12 between the linear polarization state with the polarization direction along the Z-direction and the linear polarization state with the polarization direction along the X-direction. However, without having to be limited to this, the circumferential polarization annular illumination and the radial polarization annular illumination can also be implemented, for example, by switching the variable optical rotator unit 12 between the first state shown in Fig. 5 and a second state in which the variable optical rotator unit 12 is rotated by 90° around the optical axis AX, relative to the incident light beam in the linear polarization state with the polarization direction along the Z-direction or along the X-direction.

In the above description, the variable optical rotator unit 12 is located immediately before the micro fly's eye lens 13. However, without having to be limited to this, the variable optical rotator unit 12 can be generally located on or near the pupil of the illumination optical apparatus (1-PL); for example, it may be located on or near the pupil of the projection optical system PL, on or near the pupil of the imaging optical system 17, or immediately before the conical axicon system 10 (on or near the pupil of the afocal lens 7).

In the above description, the variable optical rotator unit 12 is composed of the eight variable optical rotating members 12a-12h of the sector shape corresponding to the eight segments of the annular effective region. However, without having to be limited to this, the variable optical rotator unit 12 can also be composed, for example, of eight variable optical rotating members of a sector shape corresponding to eight segments of a circular effective region, or of four variable optical rotating members of a sector shape corresponding to four segments of a circular or annular effective region, or of sixteen variable optical rotating members of a sector shape corresponding to sixteen segments of a circular or annular effective region. Namely, a variety of modification examples can be contemplated as to the shape of the effective region of the variable optical rotator unit 12, the number of segments of the effective region (the number of variable optical rotating members), and so on.

In the above description, each variable optical rotating member 12a-12h (therefore, the variable optical rotator unit 12) is made of rock crystal. However, without having to be limited to this, each variable optical rotating member can also be made of another appropriate optical material with an optical rotatory power. In this case, it is preferable to use an optical material with the optical rotatory power of not less than 100°/mm for the light of wavelength used. Namely, when an optical material used has a small optical rotatory power, a thickness necessary for obtaining the required rotation angle of the polarization direction will be too large, so as to cause loss in quantity of light, which is not preferred.

In the above description, the variable optical rotator unit 12 is installed as fixed relative to the illumination optical path, but this variable optical rotator unit 12 may be arranged so that it can be inserted in and retracted from the illumination optical path. The above description presented the example of combination of annular illumination with s-polarized light for the wafer W, but it is also possible to adopt combinations of s-polarized light for the wafer W with multi-pole illuminations, such as dipole, quadrupole, and octupole illuminations, and with circular illumination.

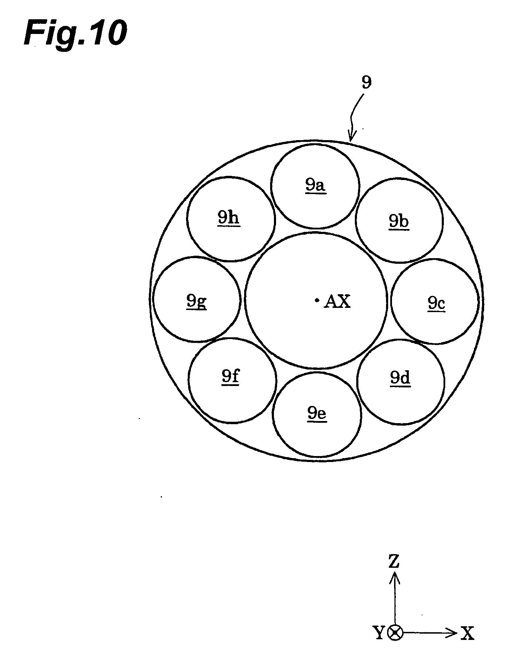

Fig. 10 is a drawing schematically showing a configuration of the variable phase difference unit according to the present embodiment. The variable phase difference unit 9 according to the present embodiment is located on or near the pupil plane of the afocal lens 7, i.e., on or near the pupil of the illumination optical system (2-17). Therefore, in the case of the annular illumination, a light beam having a substantially annular cross section around the optical axis AX is incident to the variable phase difference unit 9. In the case of the octupole illumination, for example, eight light beams having a substantially circular cross section around the optical axis AX are incident to the variable phase difference unit 9. The below will describe the case of the octupole illumination for simplicity of description.

With reference to Fig. 10, the variable phase difference unit 9 is composed of eight variable phase difference members 9a, 9b, 9c, 9d, 9e, 9f, 9g, and 9h of a circular shape arranged along a circumferential direction of a circle centered around the optical axis AX. The variable phase difference members 9a-9h have the same fundamental configuration and, specifically, each variable phase difference member is constructed as a Soleil compensator shown in Fig. 3 (a), or as a Babinet compensator shown in Fig. 3 (b).

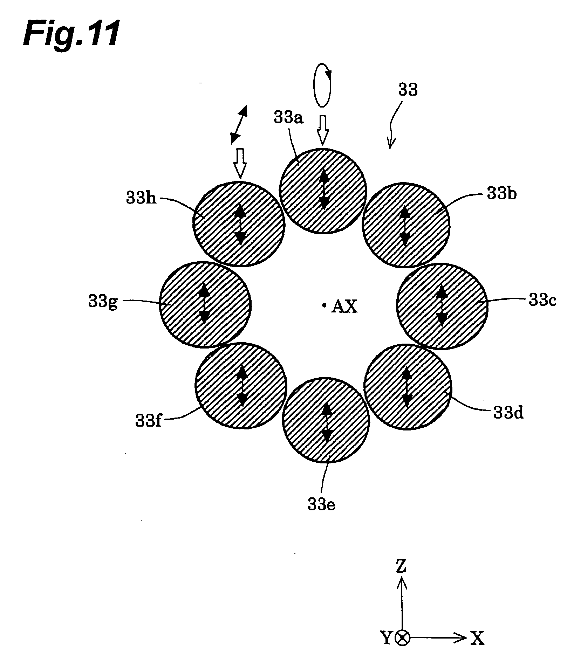

Each variable phase difference member 9a-9h is arranged, for example, to be rotatable around an axis passing the center of the circular contour and being parallel to the optical axis AX (i.e., parallel to the Y-direction). In an example where the octupole illumination is implemented in the aforementioned circumferential polarization state, as shown in Fig. 11, eight circular light beams 33a-33h constituting the octupole light beams 33 incident to the variable phase difference unit 9 all must be linearly polarized light having the polarization direction along the Z-direction by the action of the polarization state switch (3-5).

However, the polarization state of the light beams reaching the variable phase difference unit 9 can deviate from the linear polarization state with the polarization direction along the Z-direction because of influence of the polarization characteristics of the optical members or the like disposed in the optical path between the second variable phase difference member 4 and the variable phase difference unit 9. As a simple specific example, as shown in Fig. 11, the circular light beam 33a incident to the variable phase difference member 9a in the variable phase difference unit 9 turns, for example, into an elliptic polarization state, and the circular light beam 33h incident to the variable phase difference member 9h turns into a linear polarization state with the polarization direction along a direction inclined from the Z-direction.

In this case, the variable phase difference unit 9 of the present embodiment is arranged to adjust the relative positions of the first deviation prism 21b and the second deviation prism 21c (or the relative positions of the first deviation prism 22a and the second deviation prism 22b) so that the variable phase difference member 9a functions accurately as a quarter-wave plate. Also, the relative positions of the first deviation prism 21b and the second deviation prism 21c (or the relative positions of the first deviation prism 22a and the second deviation prism 22b) are adjusted so that the variable phase difference member 9h functions accurately as a half-wave plate.

Subsequently, the variable phase difference member 9a is set at a predetermined angular position around its center axis to convert incident light of elliptic polarization into linearly polarized light having the polarization direction along the Z-direction. In addition, the variable phase difference member 9h is set at a predetermined angular position around its center axis to convert incident light of linear polarization into linearly polarized light having the polarization direction along the Z-direction. In this manner, by the action of the variable phase difference unit 9 as a polarization converting element disposed on or near the illumination pupil plane, the polarization state of the incident light can be converted into a desired polarization state (the linear polarization state with the polarization direction along the Z-direction in the specific example) and, therefore, the mask M and the wafer W can be illuminated with light in the desired polarization state (e.g., the circumferential polarization state, the radial polarization state, the linear polarization state with the polarization direction along the Z-direction, or the like). Namely, when the variable phase difference unit 9 of the present embodiment is used to locally change the polarization state at a position on or near the illumination pupil plane, the mask M and the wafer W can be illuminated with the illumination light having a desired polarization state distribution on or near the illumination pupil plane and it is thus feasible to obtain effects of a desired resolution and improvement in the depth of focus and, for example, to suppress occurrence of asymmetric error in lateral or vertical directions of patterns.

The above description was given with focus on the case of octupole illumination, but the present invention is not limited to this; for example, the present invention is also applicable similarly to cases of the multi-pole illuminations, such as dipole and quadrupole illuminations, and the annular illumination so that the polarization state of incident light can be converted into a desired polarization state by the action of the variable phase difference unit 9 as a polarization converting element. In the above description, the variable phase difference unit 9 is located on or near the pupil plane of the afocal lens 7, but, without having to be limited to this, it can also be located generally on or near the pupil plane of the illumination optical system (2-17). In passing, the variable phase difference unit 9 may be arranged to be retractable from the illumination optical path or to be fixed in the illumination optical path.

In the above description, the adjustment was so made that all the octupole light beams 33a-33h immediately after passage through the variable phase difference unit 9 were in the linear polarization state with the polarization direction along the Z-direction, but, without having to be limited to this, adjustment can also be so made that the light beams immediately after passage through the variable phase difference unit 9 are in a variety of polarization states.

By further positively finely adjusting each of the variable phase difference members 9a-9h from a certain adjustment state on the basis of the measurement result by the polarization state measuring section 18, it also becomes feasible to illuminate the mask M as a surface to be illuminated and thus the wafer W with light in a greater diversity of polarization states. In this case, the controller CR adjusts each variable phase difference member 9a-9h in the variable phase difference unit 9 through the driver DR2 shown in Fig. 1.

It is also possible to adopt a combination of the variable optical rotator unit 12 shown in Fig. 5, with the variable phase difference unit 9 shown in Fig. 10. In this case, it is preferable to control an elliptical polarization rate of illumination light by the variable phase difference unit 9 and to control the polarization direction (the major-axis direction in the case of elliptical polarization) by the variable optical rotator unit 12. In this case, the variable phase difference unit 9 and the variable optical rotator unit 12 may be arranged in an adjoining state, or a relay optical system (7b, 11) may be interposed between these units so that these units 9 and 12 are arranged to be conjugate with each other.

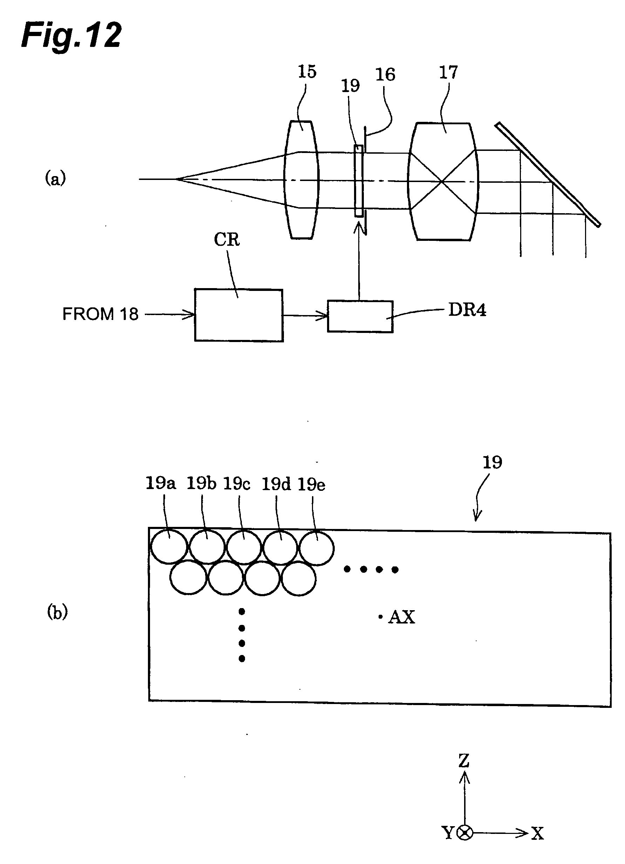

Fig. 12 is a drawing schematically showing a configuration of another variable phase difference unit according to the present embodiment. The variable phase difference unit 19 shown in Fig. 12 is located near the mask blind 16, i.e., at or near a position optically conjugate with the surface to be illuminated in the illumination optical apparatus (1-17), as shown in Fig. 12 (a). Therefore, a light beam of a rectangular shape approximately similar to the illumination region on the mask M or the exposure region on the wafer W (a still exposure region in the case of scan exposure) is incident to the variable phase difference unit 19, independent of the annular illumination, the multi-pole illuminations, the circular illumination, and so on.

With reference to Fig. 12 (b), the variable phase difference unit 19 is composed of a number of circular variable phase difference members 19a, 19b, 19c, 19d, 19e,... almost densely arranged in a rectangular region centered around the optical axis AX. The variable phase difference members (19a-19e,...) have the same fundamental configuration and, specifically, each variable phase difference member is constructed as a Soleil compensator shown in Fig. 3 (a), or as a Babinet compensator shown in Fig. 3 (b).

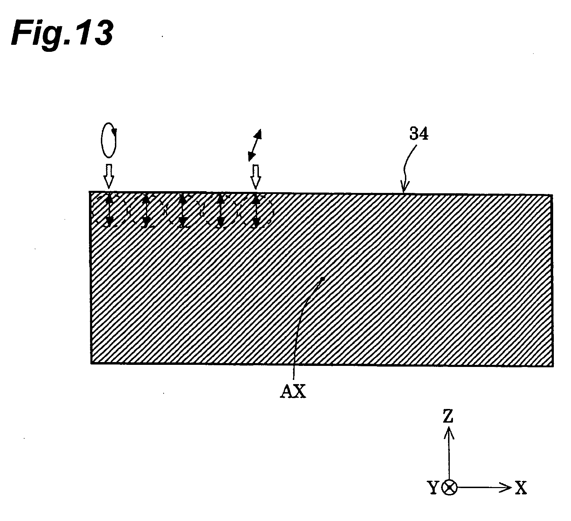

Each variable phase difference member (19a-19e,...) is arranged, for example, to be rotatable around an axis passing the center of the circular contour and being parallel to the optical axis AX (parallel to the Y-direction). In an example where the mask M and the wafer W are illuminated with light in the linear polarization state with the polarization direction along the Y-direction, as shown in Fig. 13, all the light beams incident to the respective variable phase difference members (19a-19e,...) of the variable phase difference unit 19 must be linearly polarized light having the polarization direction along the Z-direction by virtue of the action of the polarization state switch (3-5).

However, the polarization state of the light beams arriving at the variable phase difference unit 19 can deviate from the linear polarization state with the polarization direction along the Z-direction because of influence of the polarization characteristics of the optical members or the like disposed in the optical path between the second variable phase difference member 4 and the variable phase difference unit 19. In a simple specific example, as shown in Fig. 13, a light beam incident to the variable phase difference member 19a in the variable phase difference unit 19 is in an elliptical polarization state and a light beam incident to the variable phase difference member 19e is in a linear polarization state with the polarization direction along a direction inclined from the Z-direction, for example.

In this case, in the variable phase difference unit 19 of Fig. 12, the relative positions of the first deviation prism 21b and the second deviation prism 21 c (or the relative positions of the first deviation prism 22a and the second deviation prism 22b) are adjusted so that the variable phase difference member 19a functions accurately as a quarter-wave plate. Also, the relative positions of the first deviation prism 21b and the second deviation prism 21 c (or the relative positions of the first deviation prism 22a and the second deviation prism 22b) are adjusted so that the variable phase difference member 19e functions accurately as a half-wave plate.

Subsequently, the variable phase difference member 19a is set at a predetermined angular position around its center axis so as to convert the incident light of elliptical polarization into linearly polarized light having the polarization direction along the Z-direction. In addition, the variable phase difference member 19e is set at a predetermined angular position around its center axis so as to convert the incident light of linear polarization into linearly polarized light having the polarization direction along the Z-direction. In this manner, the polarization state of incident light can be converted into a desired polarization state (the linear polarization state with the polarization direction along the Z-direction in the specific example) by the action of the variable phase difference unit 19 as a polarization converting element disposed at or near the position optically conjugate with the surface to be illuminated, and the mask M and wafer W can be illuminated in the desired polarization state (the linear polarization state with the polarization direction along the Y-direction) eventually. Namely, when the polarization state of the light to illuminate the surface to be illuminated (the mask M or the wafer W) is locally changed using the other variable phase difference unit 19 according to the present embodiment, the mask M and the wafer W can be illuminated with the illumination light having the desired polarization state distribution on the surface to be illuminated and it is thus feasible to suppress variation in line widths of the pattern formed on the wafer W, depending upon positions in the illumination region, and to suppress occurrence of so-called intrafield line width difference.

It is also possible to use a combination of the variable optical rotator unit of Fig. 5 with the variable phase difference unit of Fig. 12, or a combination of the variable phase difference unit of Fig. 10 with the variable phase difference unit of Fig. 12. In this case, the polarization state of light to illuminate the surface to be illuminated (the mask M or the wafer W) is locally continuously changed while the polarization state on or near the illumination pupil plane is locally continuously changed; whereby the mask M and the wafer W can be illuminated with the illumination light having the desired polarization state distribution on or near the illumination pupil plane and having the desired polarization state distribution on the surface to be illuminated, and it is thus feasible to suppress occurrence of asymmetric error of the pattern and to suppress occurrence of the in-field line width difference.

In the above description, the variable phase difference unit 19 is located near the mask blind 16. However, without having to be limited to this, the variable phase difference unit 19 may be located near the surface to be illuminated (e.g., near the mask M) in the illumination optical apparatus (1-17), at a position optically conjugate with the surface to be illuminated, or near the conjugate position, except for the vicinity of the mask blind 16. In passing, the variable phase difference unit 19 may be arranged to be retractable from the illumination optical path or to be fixed in the illumination optical path. In the case of scan exposure, it is preferable to arrange a number of circular variable phase difference members along a non-scan direction and it is also preferable to arrange the circular variable phase difference members in a staggered array pattern (or in a zigzag pattern) in the non-scan direction.

In the above description, the adjustment was so made that all the light beams immediately after passage through the variable phase difference unit 19 were in the linear polarization state with the polarization direction along the Z-direction, but, without having to be limited to this, adjustment can also be so made that the light beams immediately after passage through the variable phase difference unit 19 are in a variety of polarization states. By further positively finely adjusting each of the variable phase difference members (19a-19e,...) from a certain adjustment state on the basis of the measurement result by the polarization state measuring section 18, it also becomes feasible to illuminate the mask M and the wafer W as a surface to be illuminated, with light in a diversity of polarization states.

In this case, as shown in Fig. 12, the controller CR is arranged to receive the measurement result from the polarization state measuring section 18, to control a driver DR4 for driving the variable phase difference members 19a-19e in the variable phase difference unit 19, and to adjust a distribution of phase difference amounts by the variable phase difference unit 19 so that the polarization state distribution of the light beam on the mask M or on the wafer W as the surface to be illuminated is in a desired state.

In the above embodiment, the variable phase difference unit 19 is located at or near the position optically conjugate with the surface to be illuminated in the illumination optical apparatus (1-17), but this variable phase difference unit may be replaced with a plurality of variable optical rotator units. In this case, the shape of each variable optical rotating member is preferably circular, instead of the sector shape as shown in Fig. 5. This configuration implements linear polarization illumination with illumination light having a desired polarization direction distribution on the surface to be illuminated. This eventually makes it feasible to implement polarization illumination with illumination light having a desired polarization state distribution on the surface to be illuminated. It is also possible to use a combination of such variable optical rotator units with a variable phase difference unit. In this case, it is preferable to control the elliptical polarization rate of illumination light by the variable phase difference unit and to control the polarization direction (the major-axis direction in the case of elliptical polarization) by the variable optical rotator units.

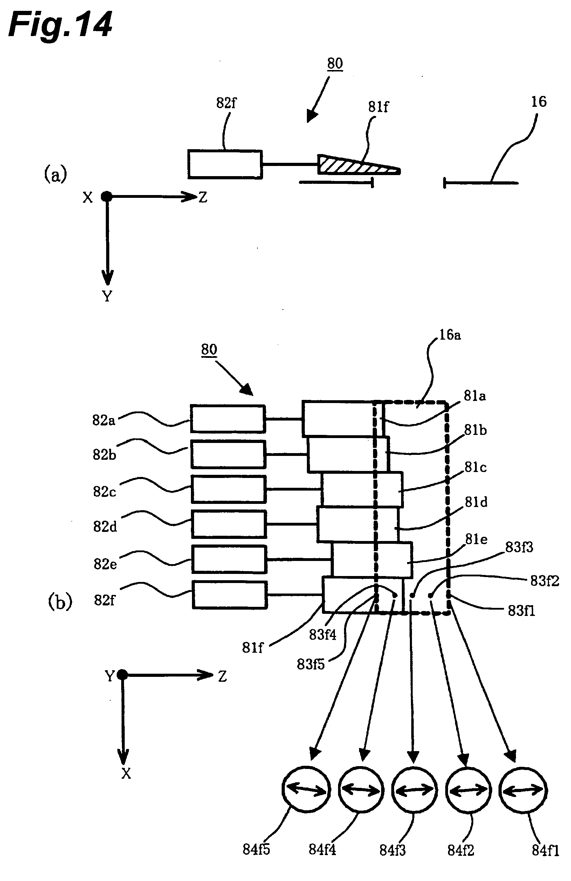

As shown as a second modification example in Fig. 14, it is also possible to arrange variable optical rotating members (variable polarization rotating members) 81a-81f formed in a wedge shape and made of an optical material with optical activity (e.g., rock crystal), along a direction corresponding to a non-scan direction (X-direction), as a variable optical rotator unit 80. These variable optical rotating members 81a-81f are movable in the direction (Z-direction) corresponding to a scan direction, and movement amounts thereof are adjusted by drive units 82a-82f controlled by the controller CR and connected to the respective variable optical rotating members 81a-81f.

The action of each variable optical rotating member 81 a-81 f will be described with reference to Fig. 14 (b). The below will describe the variable optical rotating member 81f as a representative. In Fig. 14(b), let us consider a plurality of positions 83f1-83f5 along the moving direction (Z-direction) of the variable optical rotating member 81 f. Here, polarization states of respective light beams having passed the plurality of positions 83f1-83f5 in the aperture 16a of the mask blind 16 are denoted by 84f1-84f5. When the polarization states 84f4, 84f5 of the light beams through the variable optical rotating member 81f are compared with the polarization states 84f1-84f3 of the light beams outside the variable optical rotating member 81 f, the polarization direction of incident linearly polarized light is rotated around the optical axis in accordance with the thickness of the variable optical rotating member 81 f in the optical-axis direction (Y-direction).

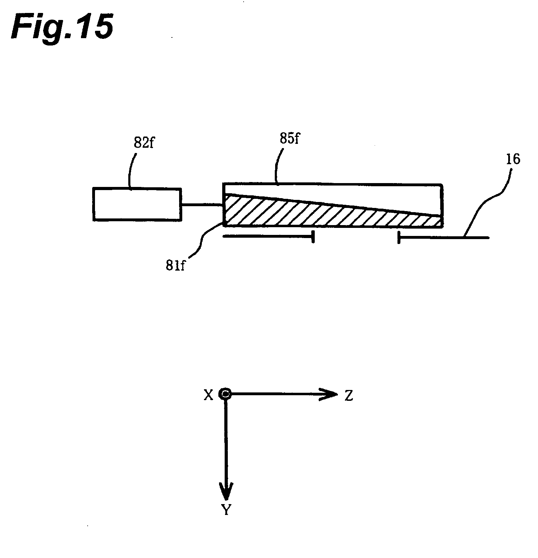

Considering the scan exposure herein, a polarization state of a light beam arriving at a point on the wafer W can be deemed as an average polarization state of a light beam group along the scan direction. Since in the second modification example the average polarization state of the polarization states 84f1-84f5 of the light beams along the Z-direction can be changed according to the Z-directional position of the variable optical rotating member 81 f, the polarization state of the light beam arriving at a point on the wafer W can be changed thereby. Then the distribution of polarization states of light beams in the non-scan direction can be changed by changing each of the Z-directional positions of the respective variable optical rotating members 81a-81f arranged along the non-scan direction. As shown in Fig. 15, the variable optical rotating members 81a-81f in the variable optical rotator unit may be provided with respective wedge optical members 85a-85f (among which only 85f is illustrated in Fig. 15) made of an amorphous material (e.g., silica glass) for correction of optical axis so that the combination is of a plane-parallel plate shape as a whole.

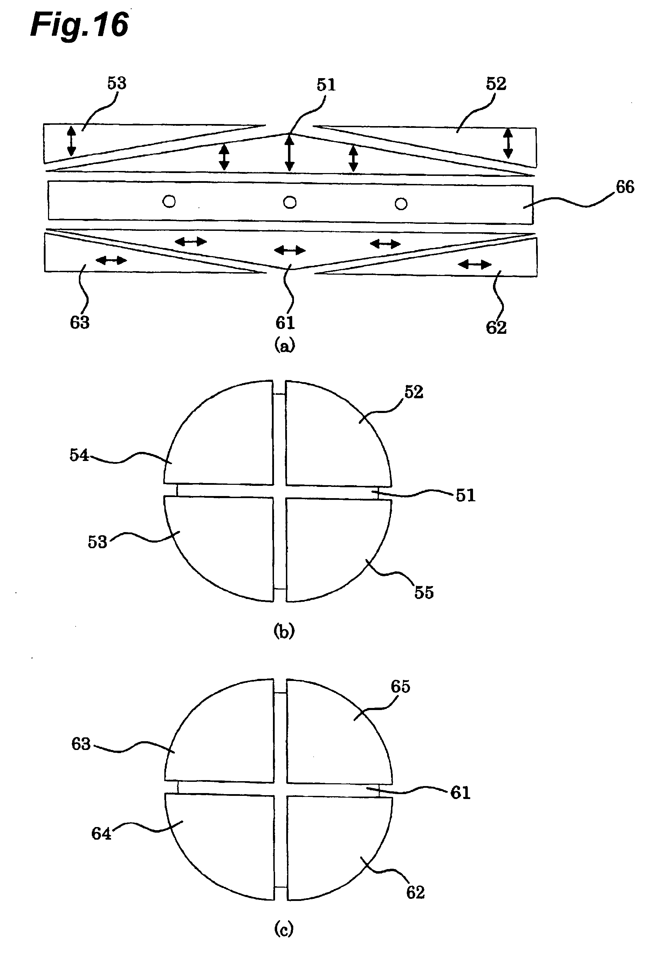

Fig. 16 is a drawing schematically showing a configuration of a variable optical rotator/phase shifter unit according to a third modification example. The third modification example is arranged to control the ellipticity of polarized light by means of variable phase shifters while controlling the polarization direction of linearly polarized light (the orientation of the major-axis direction of elliptically polarized light) by means of variable optical rotators. With reference to a side view in Fig. 16 (a), a top view in Fig. 16 (b), and a bottom view in Fig. 16 (c), each of optical rotators (variable polarization rotators) 51-55 is made of rock crystal so that the crystallographic axis thereof is aligned with the optical-axis direction, and each of phase shifters 61-66 is made of rock crystal so that the crystallographic axis thereof is aligned with a direction perpendicular to the optical axis.

Here the optical rotator 51 and the phase shifter 61 have a quadrilateral pyramid shape, and each of the optical rotators 52-55 and the phase shifter 62-65 has a wedge-shaped cross section (in a plane including the optical axis) and a quadrant shape when viewed from the optical-axis direction. In order to cancel the optical rotating action in the phase shifters 61-65, the direction of the crystallographic axes of the phase shifters 61-65 is perpendicular to the direction of the crystallographic axis of the phase shifter 66. The optical rotators 52-55 are arranged to be radially movable relative to the optical rotator 51 on the basis of the optical axis, and the phase shifters 62-65 are arranged to be radially movable relative to the phase shifter 61 on the basis of the optical axis. At this junction, the optical rotators 52-55 are preferably arranged to be movable along the slopes of the optical rotator 51 of the quadrilateral pyramid shape, and the phase shifters 62-65 are preferably arranged to be movable along the slopes of the phase shifter 61 of the quadrilateral pyramid shape.

The thickness in the optical-axis direction as an optical rotator assembly (a polarization rotating assembly) is locally changed according to the radial positions of the optical rotators 52-55. The thickness in the optical-axis direction as a phase shifter assembly is locally changed according to the radial positions of the phase shifters 62-65. Therefore, it is feasible to independently adjust optical rotation amounts and phase shift amounts given to respective light beams, i.e., a first light beam passing through the optical rotators 51, 52 and the phase shifters 61, 62, 66, a second light beam passing through the optical rotators 51, 53 and the phase shifters 61, 63, 66, a third light beam passing through the optical rotators 51, 54 and the phase shifters 61, 64, 66, and a fourth light beam passing through the optical rotators 51, 55 and the phase shifters 61, 65, 66, and it is thus feasible to independently adjust the polarization states of the first to fourth light beams (polarization directions and ellipticities).

In order to effectively adjust (correct) the phase shift amounts, it is desirable to locate the variable optical rotator unit (51-55) on the entrance side of the variable phase shift unit (61-66) as in the present modification example. When the variable optical rotator unit (51-55) is located on the exit side of the variable phase shift unit (61-66), the crystallographic axes of the phase shifters in the variable phase shift unit (51-55) can be parallel or perpendicular to the polarization direction of incident light to the phase shifters 51-55 and in this situation the incident light is not subject to the phase shift action. In this case, it is preferable to provide a phase shifter rotating mechanism for rotating the crystallographic axes of the phase shifters 51-55 in the variable phase shift unit (51-55) to an arbitrary direction in the plane perpendicular to the optical axis, or to arrange the phase shifters so as to be replaceable with other phase shifters having the crystallographic axes along other directions. The arrangement of the variable optical rotator unit and the variable phase shifter unit in the order named from the incidence side of light as described above is also effective to after-described modification examples and embodiments as well as the present modification example.

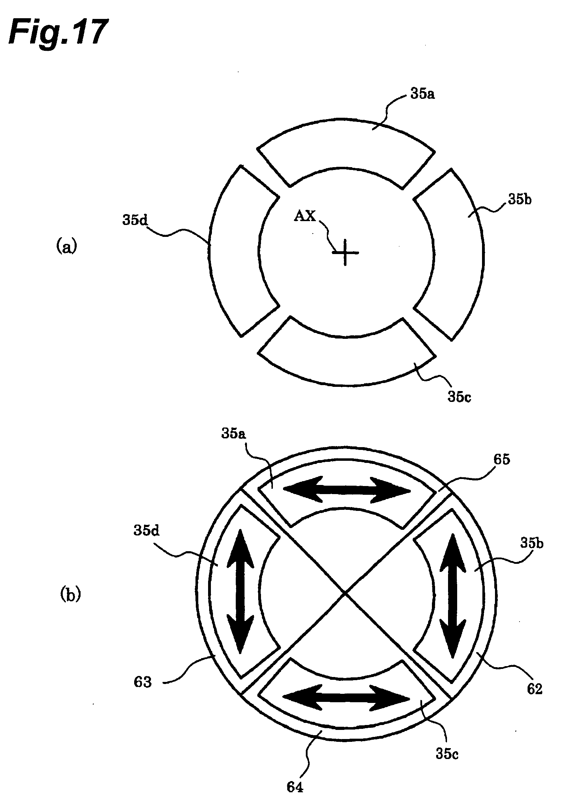

This variable optical rotator/phase shifter unit (51-55; 61-66) can be located on or near the pupil plane of the illumination optical apparatus, instead of the variable optical rotator unit 12 shown in Fig. 5 and the variable phase difference unit 9 shown in Fig. 10. In this configuration, for example, a secondary light source 35a-35d of multipole shape as shown in Fig. 17 (a) can be applied as a secondary light source formed on the pupil plane of the illumination optical apparatus. Fig. 17 (b) shows a positional relation of light beams forming the multipole secondary light source 35a-35d, at a position where they are emitted from the phase shifters 62-65 in the variable phase shifter unit (61-65). In this example of Fig. 17, each of circumferential spaces between segments of the secondary light source 35a-35d is not less than 10° as an azimuthal angle around the optical axis. This prevents the light beams forming the secondary light source 35a-35d from overlapping the borders of the divided phase shifters (optical rotators). The unit also can be located on the surface to be illuminated in the illumination optical apparatus, near the surface to be illuminated, or on one of their conjugate planes, instead of the variable phase difference unit 19 shown in Fig. 12.

The above example showed the configuration wherein the optical rotation amounts and phase shift amounts for the light beams passing through the four regions were independently controlled, but the number of regions does not

EP 1 840 945 B1

have to be limited to 4 but may be 6, 8, or any number. When the wavelength of the illumination light (exposure light) is 193 nm, the optical rotatory power of rock crystal is 90°/228 μm and the phase shift amount thereof is 180°/7 μm. When it is assumed that the variation amounts of the linear polarization direction by the optical rotators are, for example, ±20° and the phase adjustment amounts by the phase shifters ±10°, the radial stroke required for the optical rotators 52-55 is ±1 mm where the wedge angle of the optical rotators is 7.2°; the radial stroke required for the phase shifters 62-65 is 100 μm where the wedge angle of the phase shifters is 0.35°.

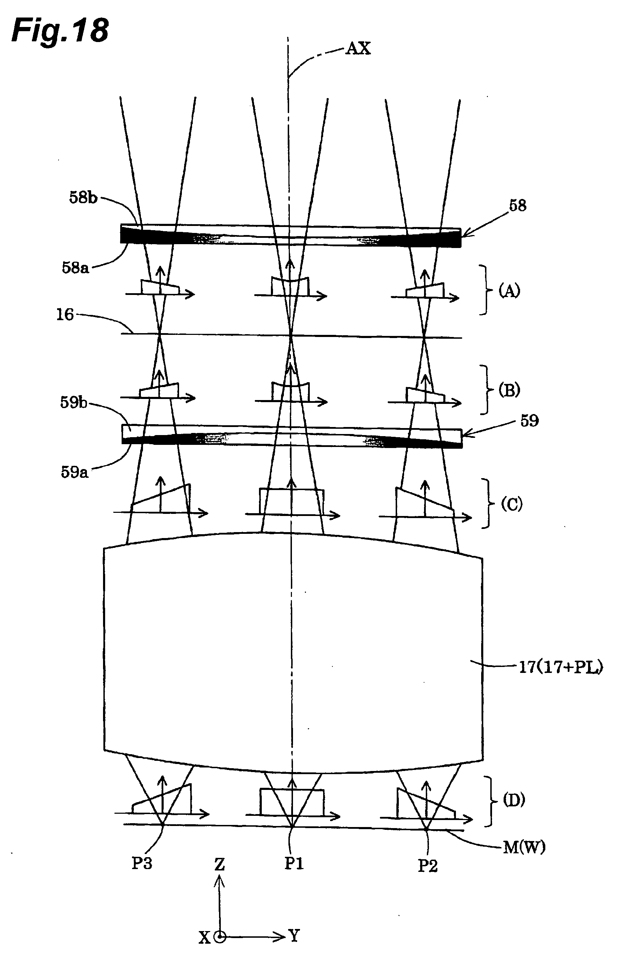

Fig. 18 is a drawing schematically showing a configuration and action of a pair of aspherical optical rotators according to a fourth modification example. In the present modification example, as shown in Fig. 18, a first aspherical optical rotator (a first aspherical polarization rotator) pair 58 is located on the front side (light source side) of the mask blind 16, and a second aspherical optical rotator (a second aspherical polarization rotator) pair 59 is located on the rear side (mask side) of the mask blind 16. The first aspherical optical rotator pair 58 has a combination of an optical rotator 58a having a concave YZ cross section, with an optical axis corrector 58b having a convex surface complementary to the concave surface of the optical rotator 58a, and the second aspherical optical rotator pair 59 has a combination of an optical rotator 59a having a convex YZ cross section, with an optical axis corrector 59b having a concave surface complementary to the convex surface of the optical rotator 59a. These first aspherical optical rotator pair 58 and second aspherical optical rotator pair 59 are so arranged that the thickness of the optical rotator differs according to positions of incidence of the light beam.

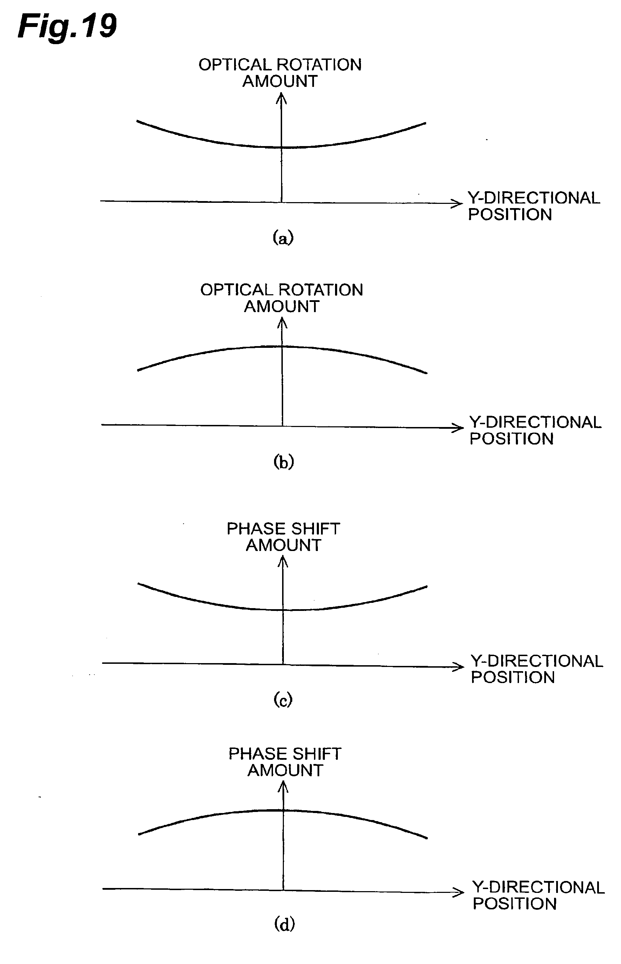

Specifically, the first aspherical optical rotator pair 58, as shown in Fig. 19 (a), has such an optical rotation distribution of a quadric concave pattern that the optical rotation amount is minimum at the center of the effective region along the Y-direction and that the optical rotation amount monotonically increases toward the periphery in accordance with a quadratic function of distance from the center, for example. On the other hand, the second aspherical optical rotator pair 59, as shown in Fig. 19 (b), has such an optical rotation distribution of a quadric convex pattern that the optical rotation amount is maximum at the center of the effective region along the Y-direction and that the optical rotation amount monotonically decreases toward the periphery in accordance with a quadratic function of distance from the center, for example.

In the present modification example, the apparatus is so set that a difference between the maximum optical rotation amount in the periphery of the effective region and the minimum optical rotation amount at the center in the first aspherical optical rotator pair 58 is equal to a difference between the maximum optical rotation amount at the center of the effective region and the minimum optical rotation amount in the periphery in the second aspherical optical rotator pair 59. Namely, the first aspherical optical rotator pair 58 has the optical rotation distribution of the quadric concave pattern, while the second aspherical optical rotator pair 59 has the optical rotation distribution of the quadric convex pattern. As a result, the first aspherical optical rotator pair 58 and the second aspherical optical rotator pair 59 come to have the optical rotation distributions complementary to each other.

In the present modification example, the apparatus is so set that a distance between the first aspherical optical rotator pair 58 (precisely, the concave surface thereof) and the mask blind 16 is equal to a distance between the second aspherical optical rotator pair 59 (precisely, the convex surface thereof) and the mask blind 16. Now, let us focus attention to a ray arriving at a center point P1 as intersecting with the optical axis AX on the mask M as a surface to be illuminated (or the wafer W as a final surface to be illuminated), a ray arriving at a point P2 a predetermined distance apart in the +Y direction from the center point P1, and a ray arriving at a point P3 the same distance apart in the -Y direction from the center point P1.

Let us consider a case where only the first aspherical optical rotator pair 58 having the optical rotation distribution of the quadric concave pattern is interposed. In Fig. 18, three graphs (A) between the first aspherical optical rotator pair 58 and the mask blind 16 represent distributions of in-aperture optical rotation amounts of respective light beams about the points P1, P2, P3, traveling in the optical path between the first aspherical optical rotator pair 58 and the mask blind 16, and three graphs (B) between the mask blind 16 and the second aspherical optical rotator pair 59 represent distributions of in-aperture optical rotation amounts of respective light beams about the points P1, P2, P3, traveling in the optical path between the mask blind and the second aspherical optical rotator pair 59.

Furthermore, three graphs (C) between the second aspherical optical rotator pair 59 and the imaging optical system 17 (or between the imaging optical system 17 and the projection optical system PL) represent distributions of in-aperture optical rotation amounts of respective light beams about the points P1, P2, P3, traveling in the optical path between the second aspherical optical rotator pair 59 and the imaging optical system 17 (or between the imaging optical system 17 and the projection optical system PL), and three graphs (D) between the imaging optical system 17 (or the imaging optical system 17 and the projection optical system PL) and the surface to be illuminated (M, W) represent distributions of in-aperture optical rotation amounts of respective light beams about the points P1, P2, P3, traveling in the optical path between the imaging optical system 17 (or the imaging optical system 17 and the projection optical system PL) and the surface to be illuminated (M, W). In these graphs (A)-(D), the vertical axis represents the optical rotation amounts and the horizontal axis the numerical apertures NA.

It is seen from the graphs (A) that between the first aspherical optical rotator pair 58 and the mask blind 16, the in-aperture optical rotation distribution about the center point P1 is a concave pattern, the in-aperture rotation distribution about the point P2 is an inclined pattern, and the in-aperture rotation distribution about the point P3 is an inclined pattern inclined in the opposite inclination direction to the inclined pattern of the point P2. It is also seen from the graphs (B) that after passage through the mask blind 16 (intermediate focus point), the in-aperture rotation distribution about the center point P1 is still a concave pattern, and the in-aperture rotation distribution about the point P2 and the in-aperture rotation distribution about the point P3 are inclined patterns inclined in opposite inclination directions.

When the second aspherical optical rotator pair 59 having the optical rotation distribution of the quadric convex pattern is also interposed in addition to the first aspherical optical rotator pair 58, the second aspherical optical rotator pair 59 acts, as shown in the graphs (C) and (D) in Fig. 18, to return the optical rotation distribution of the concave pattern about the center point P1 to a uniform pattern and to change the inclined patterns of the optical rotation distributions about the point P2 and point P3 to inclined patterns with enhanced degree of inclination.

In other words, the cooperation of the first aspherical optical rotator pair 58 and the second aspherical optical rotator pair 59 changes the optical rotation distribution about the point P2 (and points having the same Y-coordinate as P2) to the linear inclination pattern and changes the optical rotation distribution about the point P3 (and points having the same Y-coordinate as P3) to the linear inclination pattern having the inclination direction opposite to that of the inclination pattern about the point P2 and the same degree of inclination, without change in the optical rotation distribution about the center point P1 (and points having the same Y-coordinate as P1). The degree of adjustment of linear inclination of the optical rotation distributions about the points P2 and P3 is dependent upon the distance of the point P2 and the point P3 along the Y-direction from the center point P1.

Namely, the degree of linear inclination adjustment for the optical rotation distribution at a certain point increases with distance from the center point P1 along the Y-direction. It is also apparent with reference to Fig. 18 that a size of a region where rays arriving at each point on the surface to be illuminated pass each of the first aspherical optical rotator pair 58 and the second aspherical optical rotator pair 59 (hereinafter referred to as "partial region") becomes larger as the first aspherical optical rotator pair 58 and the second aspherical optical rotator pair 59 are set more distant from the mask blind 16, and that the degree of linear inclination adjustment for the optical rotation distribution about each point also increases therewith. It is a matter of course that the degree of linear inclination adjustment for the optical rotation distribution about each point also increases as the degree of change in the optical rotation distributions of the first aspherical optical rotator pair 58 and the second aspherical optical rotator pair 59 is set larger.

Since the present modification example has the configuration wherein the first aspherical optical rotator pair 58 and the second aspherical optical rotator pair 59 have the complementary optical rotation distributions and wherein the first aspherical optical rotator pair 58 and the second aspherical optical rotator pair 59 are set equidistant from the mask blind 16 on both sides thereof, as described above, the position and size of the partial region about each point on the surface to be illuminated, in the first aspherical optical rotator pair 58 are almost equal to those in the second aspherical optical rotator pair 59. As a result, the optical rotation distribution about each point on the surface to be illuminated is adjusted on a point-by-point basis by cooperation of the first aspherical optical rotator pair 58 and the second aspherical optical rotator pair 59, but there is no substantive change in the optical rotation distribution on the surface to be illuminated.

In the present modification example, as described above, the first aspherical optical rotator pair 58 and the second aspherical optical rotator pair 59 constitute an adjusting means for independently adjusting each of optical rotation distributions about respective points on the surface to be illuminated (M, W); in other words, in the present modification example the first aspherical optical rotator pair 58 and the second aspherical optical rotator pair 59 constitute an adjusting means for independently adjusting in-aperture polarization states of light beams arriving at respective points on the surface to be illuminated (M, W). As a result, the exposure apparatus of the present modification example is able to adjust the polarization state distribution at each point on the surface to be illuminated, to a desired distribution, while maintaining the optical rotation distribution almost uniform on the surface to be illuminated (M, W); therefore, the microscopic pattern of the mask M can be accurately transferred throughout the entire exposure region and in a desired line width onto the wafer W.

In the above description, the first aspherical optical rotator pair 58 and the second aspherical optical rotator pair 59 are set equidistant from the mask blind 16 on both sides thereof; however, the same effect as in the foregoing embodiment is also achieved when they are set equidistant on both sides of a conjugate plane optically conjugate with the wafer W as a final surface to be illuminated, specifically, when they are set equidistant on both sides of the mask M, for example. In the above description, the first aspherical optical rotator pair 58 has the optical rotation distribution of the quadric concave pattern and the second aspherical optical rotator pair 59 has the optical rotation distribution of the quadric convex pattern; however, the same effect as in the foregoing modification example is also achieved in a case where the first aspherical optical rotator pair 58 has an optical rotation distribution of a quadric convex pattern and the second aspherical optical rotator pair 59 has an optical rotation distribution of a quadric concave pattern.

In the above description, the first aspherical optical rotator pair 58 and the second aspherical optical rotator pair 59 are comprised of the optical rotators of rock crystal whose crystallographic axis is positioned in parallel with the optical axis, in order to provide the optical rotation distributions of the predetermined patterns; however, instead thereof, a first aspherical phase shifter pair and a second aspherical phase shifter pair may also be used, for example, by combining a phase shifter of rock crystal whose crystallographic axis is positioned perpendicularly to the optical axis, with an optical-axis corrector. In this case, for example, the first aspherical phase shifter pair has a combination of a phase shifter of a concave YZ cross section with an optical-axis corrector having a convex surface complementary to the concave surface of the phase shifter, and the second aspherical phase shifter pair has a combination of a phase shifter of a convex YZ cross section with an optical-axis corrector having a concave surface complementary to the convex surface of the phase shifter. These first aspherical phase shifter pair and second aspherical phase shifter pair are constructed in a configuration wherein the thickness of the phase shifter differs according to positions of incidence of the light beam.

Specifically, the first aspherical phase shifter pair, as shown in Fig. 19 (c), has, for example, such a phase shift amount distribution of a quadric concave pattern that the phase shift amount is minimum at the center of the effective region along the Y-direction and that the phase shift amount monotonically increases toward the periphery in accordance with a quadratic function of distance from the center. On the other hand, the second aspherical phase shift pair, as shown in Fig. 19 (d), has, for example, such a phase shift amount distribution of a quadric convex pattern that the phase shift amount is maximum at the center of the effective region along the Y-direction and that the phase shift amount monotonically decreases toward the periphery in accordance with a quadratic function of distance from the center. Each of phase shift amount distributions about respective points on the surface to be illuminated can be independently adjusted by these first aspherical phase shifter pair and the second aspherical phase shifter pair. In other words, in-aperture polarization states of light beams arriving at respective points on the surface to be illuminated (M, W) can be independently adjusted by the first aspherical phase shifter pair and the second aspherical phase shifter pair. It is also possible to use a combination of the aspherical phase shifter pairs with the aforementioned aspherical optical rotator pairs.

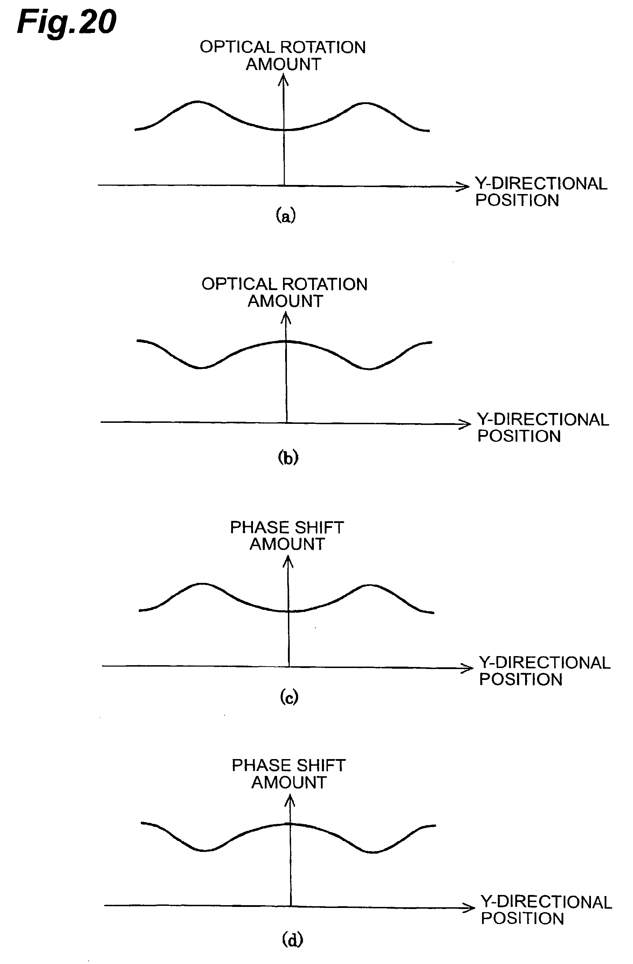

In the above description, the first aspherical optical rotator (phase shifter) pair 58 and the second aspherical optical rotator (phase shifter) pair 59 have the optical rotation (phase shift) distributions of the quadric patterns; however, without having to be limited to this, a variety of modification examples can be contemplated as to the patterns of the optical rotation (phase shift) distributions given to the first aspherical optical rotator (phase shifter) pair 58 and the second aspherical optical rotator (phase shifter) pair 59. Specifically, for example, it is also possible to contemplate a modification example wherein the first aspherical optical rotator (phase shifter) pair 58, as shown in Fig. 20 (a) or (c), has, for example, such an optical rotation (phase shift) distribution of a quartic M-shaped pattern that the transmittance increases once from the center and then decreases toward the periphery in accordance with a quartic function of distance from the center of the effective region along the Y-direction.

In this fifth modification example, the second aspherical optical rotator (phase shifter) pair 59, as shown in Fig. 20 (b) or (d), has such an optical rotation (phase shift) distribution of a quartic W-shaped pattern that the optical rotation amount (phase shift amount) decreases once from the center and then increases toward the periphery in accordance with a quartic function of distance from the center of the effective region along the Y-direction. In this case, the optical rotation (phase shift) distribution of the first aspherical optical rotator (phase shifter) pair 58 is set to be complementary to the optical rotation (phase shift) distribution of the second aspherical optical rotator (phase shifter) pair 59, with the same effect as in the foregoing modification example. However, since the first aspherical optical rotator (phase shifter) pair 58 and the second aspherical optical rotator (phase shifter) pair 59 have the optical rotation (phase shift) distributions of the quartic patterns, the inclination adjustment effect achieved is not the linear inclination adjustment, but cubical inclination adjustment. It is noted that the first aspherical optical rotator (phase shifter) pair 58 and the second aspherical optical rotator (phase shifter) pair 59 may have their respective optical rotation (phase shift) distributions of patterns higher than the quartic.

In the above description, the first aspherical optical rotator (phase shifter) pair 58 and the second aspherical optical rotator (phase shifter) pair 59 are provided with the respective one-dimensional optical rotation (phase shift) distributions along the Y-direction; i.e., the optical rotators (phase shifters) are of a cylindrical lens shape, and a variety of modification examples can be contemplated as to the variation direction of the one-directional optical rotation (phase shift) distributions. It is also possible to provide the first aspherical optical rotator (phase shifter) pair 58 and the second aspherical optical rotator (phase shifter) pair 59 with two-dimensional optical rotation (phase shift) distributions. The optical rotation (phase shift) distributions given to the first aspherical optical rotator (phase shifter) pair 58 and to the second aspherical optical rotator (phase shifter) pair 59 can also be defined according to other appropriate functions. An example is, for example, to define the optical rotation (phase shift) distributions of the first aspherical optical rotator (phase shifter) pair 58 and the second aspherical optical rotator (phase shifter) pair 59 by later-described Zernike polynomials, whereby the in-aperture polarization state distribution about each point on the surface to be illuminated can be adjusted on a point-by-point basis in accordance with a variety of forms.

Incidentally, the foregoing modification example showed the configuration wherein the first aspherical phase shifter pair and the second aspherical phase shifter pair were comprised of the phase shifters of rock crystal whose crystallographic axis was positioned perpendicularly to the optical axis, but the phase shifters are not limited to rock crystal; for example, it is also possible to apply various phase shifters including those made of a birefringent crystal material such as magnesium fluoride ($MgF_2$), those made of an optically transparent material with stress birefringence distribution, and those made of an optically transparent material with a form birefringent pattern.

In the foregoing modification example, the transmittance distribution of the first aspherical optical rotator (phase shifter) pair 58 is set to be complementary to the optical rotation (phase shift) distribution of the second aspherical optical rotator (phase shifter) pair 59; however, without having to be limited to this, it is also possible to contemplate a modification example wherein the second aspherical optical rotator (phase shifter) pair 59 is provided with an optical rotation (phase shift) distribution substantially different from the optical rotation (phase shift) distribution complementary to the optical rotation (phase shift) distribution of the first aspherical optical rotator (phase shifter) pair 58. In this modification example, the polarization state distribution on the surface to be illuminated is adjusted according to the difference between the optical rotation (phase shift) distribution complementary to the optical rotation (phase shift) distribution of the first aspherical optical rotator (phase shifter) pair 58, and the optical rotation (phase shift) distribution of the second aspherical optical rotator (phase shifter) pair 59, whereby each of polarization state distributions in the aperture (angle distributions) at respective points on the surface to be illuminated can be almost uniformly adjusted while maintaining the polarization state distribution almost constant on the surface to be illuminated.

Similarly, as a modification example of actively adjusting the polarization state distribution on the surface to be illuminated, the first aspherical optical rotator (phase shifter) pair 58 and the second aspherical optical rotator (phase shifter) pair 59 can also be set at mutually different distances on both sides of the mask blind 16. In this case, the polarization state distribution on the surface to be illuminated can be adjusted according to the difference between the distance between the mask blind 16 and the first aspherical optical rotator (phase shifter) pair 58 and the distance between the mask blind 7 and the second aspherical optical rotator (phase shifter) pair 59, whereby each of distributions of polarization states in the aperture (angle distributions) at respective points on the surface to be illuminated can be almost uniformly adjusted while maintaining the polarization state distribution almost constant on the surface to be illuminated.

In the above description, the pair of aspherical optical rotator (phase shifter) pairs (58, 59) are used to almost uniformly adjust each of distributions of polarization states in the aperture (angle distributions) at respective points on the surface to be illuminated while almost uniformly maintaining or adjusting the polarization state distribution on the surface to be illuminated. However, without having to be limited to this, the effect of the present invention can also be generally achieved by means of an adjusting means consisting of a plurality of aspherical optical rotators or aspherical phase shifters having predetermined optical rotation distributions or phase shift distributions. Namely, it is possible to contemplate a variety of modification examples as to the number and arrangement of aspherical optical rotators (phase shifters) constituting the adjusting means.

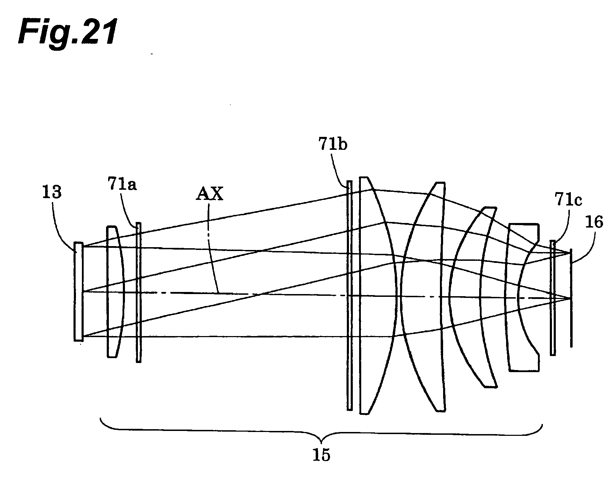

Specifically, for example as shown in Fig. 21, it is also possible to contemplate a sixth modification example using three aspherical optical rotators (phase shifters) 71a-71c having their respective optical rotation (phase shift) distributions in which the optical rotation (phase shift) differs according to positions of incidence. In the sixth modification example of Fig. 21, the first aspherical optical rotator (phase shifter) 71a and the second aspherical optical rotator (phase shifter) 71b are arranged in order from the light source side in the optical path of the condenser optical system 15 between the micro fly's eye lens 13 and the mask blind 16, and the third aspherical optical rotator (phase shifter) 71c is disposed in the optical path between the condenser optical system 15 and the mask blind 16.

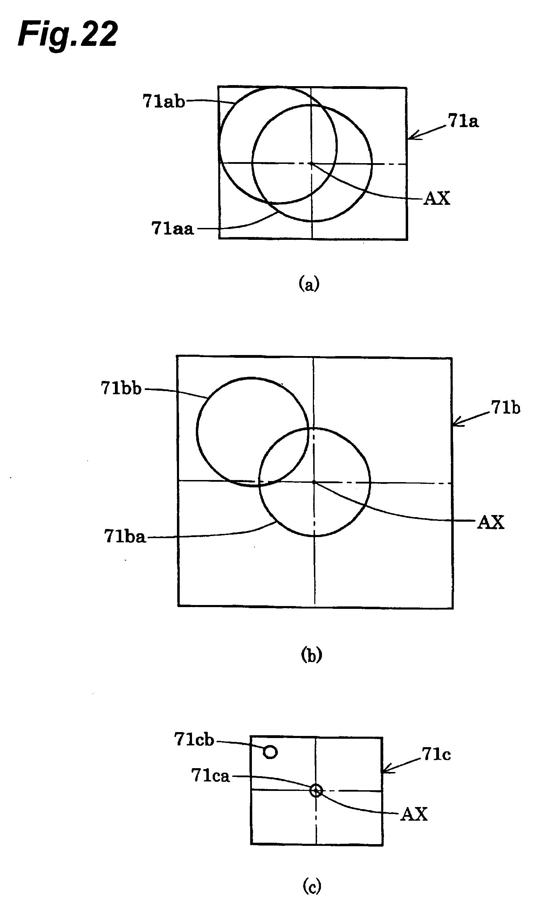

In this case, as shown in Fig. 22, regions where an on-axis light beam (a light beam arriving at an intersection between the mask blind 16 and the optical axis AX) passes through the respective aspherical optical rotators (phase shifters) 71a-71c, i.e., on-axis partial regions 71aa, 71ba, 71ca are different among the aspherical optical rotators (phase shifters) 71a-71c. Similarly, regions where an off-axis light beam (a light beam arriving at a point on the mask blind 16 distant from the optical axis AX) passes through the respective aspherical optical rotators (phase shifters) 71a-71c, i.e., off-axis partial regions 71ab, 71bb, 71cb are also different among the aspherical optical rotators (phase shifters) 71a-71c.

In this sixth modification example, while the polarization state distribution on the surface to be illuminated is almost uniformly adjusted, each of polarization state distributions in the aperture at respective points on the surface to be illuminated can be almost uniformly adjusted, by properly setting the optical rotation (phase shift) distributions of the respective aspherical optical rotators (phase shifters) 71a-71c, the positions and sizes of the on-axis partial regions and the off-axis partial regions in the respective aspherical optical rotators (phase shifters) 71a-71c, and so on. Furthermore, the effect of the present invention can be generally achieved by properly setting the optical rotation (phase shift) distributions of the respective aspherical optical rotators (phase shifters), the positions and sizes of the on-axis partial regions and the off-axis partial regions in the respective aspherical optical rotators (phase shifters), etc., using the adjusting means consisting of a plurality of aspherical optical rotators (phase shifters) having predetermined optical rotation (phase shift) distributions in which the optical rotation (phase shift) varies according to positions of incidence.

Now, let the configuration from the light source 1 to the projection optical system PL be an illumination optical apparatus for illuminating the wafer W as a surface to be illuminated, and let us describe an adjustment method for adjusting this illumination optical apparatus (1-PL). In the present embodiment, for simplicity of description of the adjustment method, it is assumed that a plurality of (two or more) aspherical optical rotators (phase shifters) having predetermined optical rotation (phase shift) distributions are used to almost uniformly adjust each of distributions of polarization states in the aperture at respective points on the surface to be illuminated, while almost uniformly adjusting the polarization state distribution on the surface to be illuminated (the plane where the wafer W is set).

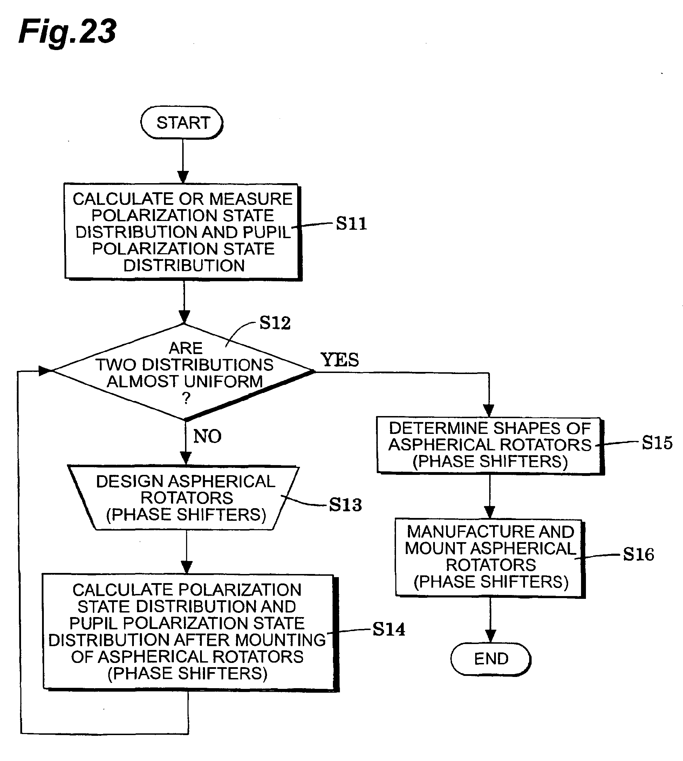

Fig. 23 is a flowchart schematically showing steps in an adjustment method of the illumination optical apparatus according to the present embodiment. In the adjustment method of the illumination optical apparatus (1-PL) according to the present embodiment, as shown in Fig. 23, the first step is to acquire a distribution of polarization states in the aperture about a plurality of points on the surface to be illuminated (pupil polarization state distribution) and a distribution of polarization states on the surface to be illuminated (S11). Specifically, the distribution acquisition step S11 is to calculate the distribution of polarization states in the aperture about a plurality of points on the surface to be illuminated and the distribution of polarization states on the surface to be illuminated, based on design data of the illumination optical apparatus (1-PL).

The design data of the illumination optical apparatus (1-PL) used herein includes, for example, data of the optical system (15-PL) from just after the micro fly's eye lens 13 to just before the wafer W, i.e., data such as curvature radii of respective optical surfaces, axial separations of respective optical surfaces, refractive indices and types of optical materials forming the respective optical members, the wavelength of used light, optical rotations (phase shifts) of the respective optical members, and incidence angle characteristics of antireflection films and reflecting films (optical rotation amounts and phase shift (retardation) amounts). Reference is made, for example, to U.S. Pat. No. 6,870,668 as to how to calculate the distribution of polarization states in the aperture about a plurality of points on the surface to be illuminated, based on the design data.

Alternatively, the distribution acquisition step S11 may be to measure the distribution of polarization states in the aperture about a plurality of points on the surface to be illuminated and the distribution of polarization states on the surface to be illuminated, with each of apparatus produced actually. Specifically, for example, the polarization state measuring section 18 shown in Fig. 2 can be used to measure the distribution of polarization states in the aperture about a plurality of points on the surface to be illuminated and the distribution of polarization states on the surface to be illuminated.

In the present embodiment, a distribution of degrees of specific polarization ($DSP_1$, $DSP_2$, $DSP_3$) defined by the Stokes parameters ($S_o$, $S_1$, $S_2$, $S_3$) can be used as each of the polarization state distribution in the aperture about plural points on the surface to be illuminated (i.e., in the pupil about each of plural points on the surface to be illuminated). Here the degree of specific polarization $DSP_1$ is represented by a ratio $S_1/S_0$ of the Stokes parameter $S_1$ to the Stokes parameter $S_0$ for rays passing a point on the pupil and reaching a point on the image plane. Similarly, the degree of specific polarization $DSP_2$ is represented by a ratio $S_2/S_0$ of the Stokes parameter $S_2$ to the Stokes parameter $S_0$ for rays passing a point on the pupil and reaching a point on the image plane, and the degree of specific polarization $DSP_3$ by a ratio $S_3/S_0$ of the Stokes parameter $S_3$ to the Stokes parameter $S_0$ for rays passing a point on the pupil and reaching a point on the image plane. It is noted herein that $S_0$ represents the overall intensity, $S_1$ a horizontal linear polarization intensity - vertical linear polarization intensity, $S_2$ a 45° linear polarization intensity - 135° linear polarization intensity, and $S_3$ a right-handed circular polarization intensity - left-handed circular polarization intensity.

In the adjustment method of the present embodiment, the next step is to determine whether each of the distribution of polarization states in the aperture about plural points on the surface to be illuminated and the distribution of polarization states on the surface to be illuminated, which were obtained by the calculation based on the design data or by the measurement using the polarization state measuring section 18, is almost uniform to a desired extent (S12). When it is determined in the determination step S12 that at least one of the in-aperture polarization state distribution and the polarization state distribution is not so uniform to the desired extent (in the case of NO in the drawing), the flow proceeds to a design step S 13 of aspherical optical rotators (phase shifters). On the other hand, when it is determined in the determination step S12 that both of the in-aperture polarization state distribution and the polarization state distribution are almost uniform to the desired extent (in the case of YES in the drawing), the flow proceeds to a shape determining step S15 of aspherical optical rotators (phase shifters).

The design step S13 is to independently adjust each of distributions of polarization states in the aperture about plural points on the surface to be illuminated, so that both of the in-aperture polarization state distribution and the polarization state distribution become almost uniform to the desired extent, and to determine (or calculate) the required optical rotation (phase shift) distributions to be given to the respective aspherical optical rotators (phase shifters), for adjusting the distribution of polarization states on the surface to be illuminated, according to need. Specifically, the number and positions of aspherical optical rotators (phase shifters) to be used are prefigured with reference to the information about the in-aperture polarization state distribution and the polarization state distribution calculated or measured, and the optical rotation (phase shift) distributions to be given to the respective aspherical optical rotators (phase shifters) are determined for almost uniformly adjusting each of distributions of polarization states in the aperture at respective points on the surface to be illuminated while almost uniformly maintaining or adjusting the distribution of polarization states on the surface to be illuminated.

The next step is to calculate the distribution of polarization states in the aperture about plural points on the surface to be illuminated (pupil polarization state distributions) and the distribution of polarization states on the surface to be illuminated in a state in which the plurality of aspherical optical rotators (phase shifters) provided with the optical rotation (phase shift) distributions determined in the design step S 13 are located at their respective prefigured positions, i.e., in a mounted state of the aspherical optical rotators (phase shifters) (S14). Specifically, the distribution calculation step S14 is to calculate the in-aperture polarization state distribution and the polarization state distribution with reference to the information about the optical rotation (phase shift) distributions and positions of the respective aspherical optical rotators (phase shifters) in addition to the aforementioned design data information.

The next step is to determine whether each of the distribution of polarization states in the aperture about plural points on the surface to be illuminated and the distribution of polarization states on the surface to be illuminated, which were calculated in the distribution calculation step S 14, is almost uniform to the desired extent (S12). When it is determined in the determination step S12 that at least one of the in-aperture polarization state distribution and the polarization state distribution is not so uniform to the desired extent (in the case of NO in the drawing), the flow proceeds again to the design step S13 of aspherical optical rotators (phase shifters). On the other hand, when it is determined in the determination step S12 that both of the in-aperture polarization state distribution and the polarization state distribution are almost uniform to the desired extent (in the case of YES in the drawing), the flow proceeds to the shape determination step S15 of aspherical optical rotators (phase shifters).

For example, after repetitive trial-and-error execution of the design step S13 and the distribution calculation step S14, the flow proceeds to the shape determination step S15 to determine the surface shapes of the aspherical optical rotators (phase shifters) necessary for realizing the required optical rotation (phase shift) distributions (the optical rotation (phase shift) distributions given to the respective aspherical optical rotators (phase shifters)) calculated in the design step S13. The last step is to manufacture a plurality of aspherical optical rotators (phase shifters) having the surface shapes determined in the shape determination step S15 and optical-axis correctors having surface shapes complementary to the aforementioned surface shapes, and to incorporate the manufactured aspherical optical rotators (phase shifters) at the respective predetermined positions in the optical system (S16). As described above, the shape determination step S15 and the manufacturing-mounting step S16 constitute an adjustment step of forming and placing each of the plurality of aspherical optical rotators (phase shifters) having the required optical rotation (phase shift) distributions. The adjustment method of the present embodiment is completed in this manner.

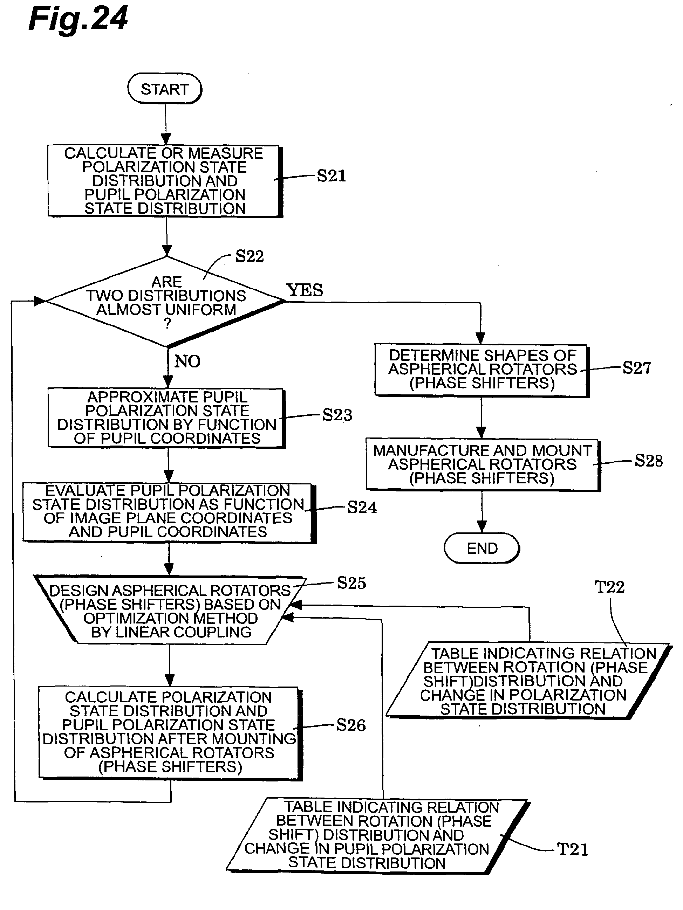

The next modification example of the present embodiment will illustrate an adjustment method capable of readily and accurately determining the required optical rotation (phase shift) distributions to be given to the respective aspherical optical rotators (phase shifters), instead of the trial-and-error method. Fig. 24 is a flowchart schematically showing steps in the adjustment method according to the modification example of the present embodiment. In the adjustment method of the modification example shown in Fig. 24, just as in the adjustment method shown in Fig. 23, the first step is to obtain the distribution of polarization states in the pupil about a plurality of points on the surface to be illuminated (in-pupil polarization state distribution or pupil polarization state distribution) and the distribution of polarization states on the surface to be illuminated (S21). Specifically, the distribution acquisition step S21 is to calculate the in-pupil polarization state distribution about plural points on the surface to be illuminated and the distribution of polarization states on the surface to be illuminated, based on the design data of the illumination optical apparatus (1-PL). Alternatively, the aforementioned polarization measuring section 18 is used to measure the in-pupil polarization state distribution about plural points on the surface to be illuminated and the distribution of polarization states on the surface to be illuminated, with each of apparatus produced actually.

The next step, just as in the adjustment method shown in Fig. 23, is to determine whether each of the in-pupil polarization state distribution about plural points on the surface to be illuminated and the distribution of polarization states on the surface to be illuminated, which were obtained by the calculation based on the design data or by the measurement using the polarization measuring section 18, is almost uniform to a desired extent (S22). When it is determined in the determination step S22 that at least one of the in-pupil polarization state distribution and the polarization state distribution is not so uniform to the desired extent (in the case of NO in the drawing), the flow proceeds to an approximation step S23 of the in-pupil polarization state distribution. On the other hand, when it is determined in the determination step S22 that both of the in-pupil polarization state distribution and the polarization state distribution are almost uniform to the desired extent (in the case of YES in the drawing), the flow proceeds to a shape determination step S27 of aspherical optical rotators (phase shifters).

The approximation step S23 of the in-pupil polarization state distribution is to approximate an in-pupil polarization state distribution about each point on the surface to be illuminated, acquired in the distribution acquisition step S21, by a predetermined polynomial as a function of pupil coordinates on the illumination pupil plane. In the present embodiment, for example, in the case of dipole illumination or annular illumination, Zernike Annular polynomials are used to express a distribution of polarization states in the pupil of illumination light by a distribution of the degrees of specific polarization DSP ($DSP_1$, $DSP_2$, $DSP_3$). This is because the shape of the effective light source region in the pupil is a ring shape (annular shape) in the annular illumination and because the effective light source regions of dipole shape in the pupil occupy parts of the ring region in the dipole illumination. In the expression of the Zernike annular polynomials to represent the in-pupil distribution of degrees of specific polarization DSP, pupil polar coordinates ($\rho$, $\theta$) are used as a coordinate system, and Zernike annular cylindrical functions are used as a system of orthogonal functions.

Namely, the degrees of specific polarization DSP($\rho$, $\theta$) are expanded as in Eq (b) below, using the Zernike annular cylindrical functions AZi($\rho$, $\theta$).

$$\mathrm{DSP}(\rho,\ \theta) = \Sigma\, \mathrm{Ci}\cdot\mathrm{AZi}(\rho,\ \theta)$$

$$= \mathrm{C1}\cdot\mathrm{AZ1}(\rho,\ \theta) + \mathrm{C2}\cdot\mathrm{AZ2}(\rho,\ \theta)$$

$$\cdots\cdots + \mathrm{Cn}\cdot\mathrm{AZn}(\rho,\ \theta) \qquad (b)$$

In this equation, Ci represents coefficients of respective terms of the Zernike annular polynomials. Table (1) below presents only the functions AZ1-AZ16 for the first term to the sixteenth term, out of the function system AZi($\rho$, $\theta$) in the terms of the Zernike annular polynomials. "$\varepsilon$" in the functions AZ2-AZ16 represents an annular ratio of a circular ring region which the effective light source region partially or wholly occupies in the pupil (i.e., inside diameter/outside diameter of the ring region = $\sigma$ inner/$\sigma$ outer).

[TABLE 1]

AZ1   $1$

AZ2   $\dfrac{\rho\cos\theta}{\sqrt{1+\varepsilon^2}}$

AZ3   $\dfrac{\rho\sin\theta}{\sqrt{1+\varepsilon^2}}$

AZ4   $\dfrac{2\rho^2-1-\varepsilon^2}{1-\varepsilon^2}$

AZ5   $\dfrac{\rho^2\cos2\theta}{\sqrt{1+\varepsilon^2+\varepsilon^4}}$

AZ6   $\dfrac{\rho^2\sin2\theta}{\sqrt{1+\varepsilon^2+\varepsilon^4}}$

AZ7   $\dfrac{(3\rho^3(1+\varepsilon^2)-2\rho(1+\varepsilon^2+\varepsilon^4))\cos\theta}{(1-\varepsilon^2)\sqrt{(1+\varepsilon^2)(1+4\varepsilon^2+\varepsilon^4)}}$

AZ8   $\dfrac{\left(3\rho^3(1+\varepsilon^2)-2\rho(1+\varepsilon^2+\varepsilon^4)\right)\sin\theta}{\left(1-\varepsilon^2\right)\sqrt{1+5\varepsilon^2+5\varepsilon^4+\varepsilon^6}}$

AZ9   $\dfrac{6\rho^4-6\rho^2(1+\varepsilon^2)+(1+4\varepsilon^2+\varepsilon^4)}{(1-\varepsilon^2)^2}$

AZ10   $\dfrac{\rho^3\cos3\theta}{\sqrt{1+\varepsilon^2+\varepsilon^4+\varepsilon^6}}$

(continued)

AZ11
$$\frac{\rho^3 \sin 3\theta}{\sqrt{1+\varepsilon^2+\varepsilon^4+\varepsilon^6}}$$

AZ12
$$\frac{\sqrt{(1-\varepsilon^2)}(4\rho^4(1+\varepsilon^2+\varepsilon^4)-3\rho^2(1+\varepsilon^2+\varepsilon^4+\varepsilon^6))\cos 2\theta}{\sqrt{1+4\varepsilon^2+10\varepsilon^4+4\varepsilon^6+\varepsilon^8}}$$

AZ13
$$\frac{\sqrt{(1-\varepsilon^2)}(4\rho^4(1+\varepsilon^2+\varepsilon^4)-3\rho^2(1+\varepsilon^2+\varepsilon^4+\varepsilon^6))\sin 2\theta}{\sqrt{1+4\varepsilon^2+10\varepsilon^4+4\varepsilon^6+\varepsilon^8}}$$

AZ14
$$\frac{(10\rho^5(1+4\varepsilon^2+\varepsilon^4)-12\rho^3(1+4\varepsilon^2+4\varepsilon^4+\varepsilon^6)+3\rho(1+4\varepsilon^2+10\varepsilon^4+4\varepsilon^6+\varepsilon^8))\cos\theta}{(1-\varepsilon^2)^2\sqrt{1+13\varepsilon^2+46\varepsilon^4+46\varepsilon^6+13\varepsilon^8+\varepsilon^{10}}}$$

AZ15
$$\frac{(10\rho^5(1+4\varepsilon^2+\varepsilon^4)-12\rho^3(1+4\varepsilon^2+4\varepsilon^4+\varepsilon^6)+3\rho(1+4\varepsilon^2+10\varepsilon^4+4\varepsilon^6+\varepsilon^8))\sin\theta}{(1-\varepsilon^2)^2\sqrt{1+13\varepsilon^2+46\varepsilon^4+46\varepsilon^6+13\varepsilon^8+\varepsilon^{10}}}$$

AZ16
$$\frac{20\rho^6-30\rho^4(1+\varepsilon^2)+12\rho^2(1+3\varepsilon^2+\varepsilon^4)-(1+9\varepsilon^2+9\varepsilon^4+\varepsilon^6)}{(1-\varepsilon^2)^3}$$

.
.

$$\varepsilon = \frac{\sigma_{inner}}{\sigma_{outer}}$$

On the other hand, for example, in the case of circular illumination, the Fringe Zernike polynomials are used to express a distribution of polarization states in the pupil of illumination light by a distribution of degrees of specific polarization DSP (DSP$_1$, DSP$_2$, DSP$_3$). This is because the shape of the effective light source region in the pupil is circular in the circular illumination. In the expression of the Fringe Zernike polynomials to express the in-pupil distribution of degrees of specific polarization DSP, the pupil polar coordinates ($\rho$, $\theta$) are used as a coordinate system, and the Fringe Zernike cylindrical functions are used as a system of orthogonal functions.

Namely, the degrees of specific polarization DSP($\rho$, $\theta$) are expanded as in Eq (c) below, using the Fringe Zernike cylindrical functions FZi($\rho$, $\theta$).

$$DSP(\rho,\ \theta) = \Sigma Bi \cdot FZi(\rho,\ \theta)$$

$$= B1 \cdot FZ1(\rho,\ \theta) + B2 \cdot FZ2(\rho,\ \theta)$$

$$\cdots\cdots + Bn \cdot FZn(\rho,\ \theta) \quad (c)$$

In this equation, Bi represents the coefficients of the respective terms of the Fringe Zernike polynomials. Table (2) below presents only the functions FZ1-FZ16 for the first term to the sixteenth term, out of the function system FZi($\rho$, $\theta$) in the terms of the Fringe Zernike polynomials.

TABLE (2)

| | |
|---|---|
| FZ1: | 1 |
| FZ2: | $\rho \cos \theta$ |
| FZ3: | $\rho \sin \theta$ |
| FZ4: | $2\rho^2 - 1$ |

(continued)

| | |
|---|---|
| FZ5: | $\rho^2\cos2\,\theta$ |
| FZ6: | $\rho^2\sin2\,\theta$ |
| FZ7: | $(3\,\rho^2\text{-}2)\,\rho\,\cos\,\theta$ |
| FZ8 : | $(3\,\rho^2\text{-}2)\,\rho\,\sin\,\theta$ |
| FZ9: | $6\,\rho^4\text{-}6\,\rho^2\text{+}1$ |
| FZ10: | $\rho^3\cos3\,\theta$ |
| FZ11: | $\rho^3\sin3\,\theta$ |
| FZ12: | $(4\,\rho^2\text{-}3)\,\rho^2\cos2\,\theta$ |
| FZ13: | $(4\,\rho^2\text{-}3)\,\rho^2\sin2\,\theta$ |
| FZ14: | $(10\,\rho^4\text{-}12\,\rho^2\text{+}3)\,\rho\,\cos\,\theta$ |
| FZ15: | $(10\,\rho^4\text{-}12\rho^2\text{+}3)\,\rho\,\sin\theta$ |
| FZ16: | $20\,\rho^6\,\text{-}30\,\rho^4\,\text{+}12\,\rho^2\,\text{-}1$ |

⋮

In the adjustment method of the present modification example, the next step is to evaluate a distribution of polarization states about each point by a polarization state distribution polynomial as a function of the image-plane polar coordinates (h, $\alpha$) and the pupil polar coordinates (p, $\theta$), based on the coefficients $C_i$ of the respective terms in the Zernike polynomials acquired in the approximation step S23 (S24). Specifically, the evaluation step S24 is to set the polarization state distribution polynomial that expresses the polarization state distribution about each point as a function of the image-plane polar coordinates (h, $\alpha$) and the pupil polar coordinates (p, $\theta$). As to the setting of the polarization state distribution polynomial, reference is made to U.S. Published Application No. US2003/0206289 and Japanese Patent Application Laid-Open No. 2005-12190.

The foregoing Applications describe the setting of an aberration polynomial that expresses the wavefront aberration of the projection optical system as a function of the image-plane polar coordinates (h, $\alpha$) and the pupil polar coordinates (p, $\theta$), and it is apparent that the polarization state distribution polynomial can be set by a similar technique. In this manner, the evaluation step S24 is arranged to determine the coefficients of the respective terms in the polarization state distribution polynomial, based on the Zernike coefficients $C_i$ of the respective terms in the Zernike polynomials acquired in the approximation step (S23), and thus to express and evaluate the polarization state distribution about each point by the polarization state distribution polynomial.

Specifically, as disclosed in the foregoing Applications and others, attention is focused, for example, to a Zernike function $Z_i$ of a specific term, and a coefficient of the specific term in the polarization state distribution polynomial is determined, for example, by the least-square method, based on a distribution in the image plane of the corresponding Zernike coefficient $C_i$ (distribution of coefficient $C_i$ at each of points). Furthermore, attention is focused to a Zernike function $Z_i$ of another specific term, and a coefficient of the other term in the polarization state distribution polynomial is subsequently determined, for example, by the least-square method, based on a distribution in the image plane of the corresponding Zernike coefficient $C_i$.

In this way, the evaluation step S24 results in finally obtaining the polarization state distribution polynomial simultaneously expressing the in-pupil distribution and the in-image-plane distribution of polarization state distributions. By using the polarization state distribution polynomial simultaneously expressing the in-pupil distribution and the in-image-plane distribution of polarization state distributions in this way, it becomes feasible to analytically decompose the polarization state distribution and to calculate an optical adjustment solution more quickly and accurately than by the trial-and-error technique of numerical optimization with a computer. Namely, it becomes easier to capture features of the polarization state distribution situation by the polarization state distribution polynomial and it becomes easier to have a perspective on optical adjustment.

The next design step S25 of aspherical optical rotators (phase shifters) is to independently adjust each of polarization state distributions about plural points on the surface to be illuminated so that both of the pupil polarization state distribution and the polarization state distribution in the surface to be illuminated are almost uniform to the desired extent and to determine (or calculate) required optical rotation (phase shift), distributions to be given to the respective aspherical optical rotators (phase shifters), for adjusting the polarization state distribution on the surface to be illuminated, according to need. Specifically, the distribution of polarization states on the surface to be illuminated (image plane), acquired in the distribution acquisition step S21, is first approximated by Zernike polynomials as functions of image-plane polar coordinates (h, $\alpha$) according to need.

Furthermore, the optical rotation (phase shift) distribution to be given to each aspherical optical rotator (phase shifter) is expressed, for example, by Zernike polynomials using the polar coordinates on an optical surface of the aspherical optical rotator (phase shifter). Then prepared are a first table T21 indicating a relation between coefficients of the respective terms in the Zernike polynomials expressing the optical rotation (phase shift) distribution of each aspherical optical rotator (phase shifter), and change in the pupil polarization state distribution about each point on the surface to be illuminated, and a second table T22 indicating a relation between coefficients of the respective terms in the Zernike polynomials expressing the optical rotation (phase shift) distribution of each aspherical optical rotator (phase shifter), and change in the polarization state distribution on the surface to be illuminated,

In this way, the design step S25 is to determine the optical rotation (phase shift) distributions to be given to the respective aspherical optical rotators (phase shifters), for almost uniformly adjusting each of distributions of pupil polarization states at respective points on the surface to be illuminated while almost uniformly maintaining or adjusting the polarization state distribution on the surface to be illuminated, based on the evaluation result about the polarization state distribution acquired in the evaluation step S24 (specifically, the polarization state distribution polynomial simultaneously expressing the in-pupil distribution and the in-image-plane distribution of polarization state distributions), and optionally based on an optimization technique by linear coupling with reference to the polarization state distribution information approximated by the Zernike polynomials, the correlation between the optical rotation (phase shift) distributions of the respective aspherical optical rotators (phase shifters) and the change in the pupil polarization state distribution in the first table T21, and the correlation between the optical rotation (phase shift) distributions of the respective aspherical optical rotators (phase shifters) and the change in the polarization state distribution in the second table T22.

The next step is to calculate the pupil polarization state distribution about plural points on the surface to be illuminated and the polarization state distribution on the surface to be illuminated, in a state in which the plurality of aspherical optical rotators (phase shifters) provided with the optical rotation (phase shift) distributions determined in the design step S25 are placed at their respective prefigured positions, i.e., in a mounted state of the aspherical optical rotators (phase shifters) (S26). Furthermore, it is determined whether each of the pupil polarization state distribution about plural points on the surface to be illuminated and the polarization state distribution on the surface to be illuminated, which were calculated in the distribution calculation step S26, is almost uniform to the desired extent (S22). Since the required optical rotation (phase shift) distributions were readily and accurately determined by the optimization technique based on linear coupling, instead of the trial-and-error method, the determination step S22 results in determining that both of the pupil polarization state distribution and the polarization state distribution are almost uniform to the desired extent, and the flow proceeds to the shape determination step S27 of aspherical optical rotators (phase shifters).

The shape determination step S27 is to determine the surface shapes of the aspherical optical rotators (phase shifters) necessary for realizing the required optical rotation (phase shift) distributions calculated in the design step S25. The last step is to manufacture the plurality of aspherical optical rotators (phase shifters) having the surface shapes determined in the shape determination step S27 and optical-axis correctors having surface shapes complementary to the foregoing surface shapes, and to incorporate each of the manufactured aspherical optical rotator (phase shifter) pairs at predetermined positions in the optical system (S28). The adjustment method of the modification example is completed in this way.

The adjustment method according to the above-described embodiment or modification example is also applicable, for example, to adjustment of a plurality of exposure apparatus installed in a semiconductor manufacturing factory. In this case, the plurality of exposure apparatus are desirably adjusted so as to have their respective polarization states identical with each other. This makes OPC (optical proximity correction) for masks used by a user of the exposure apparatus, common among the plurality of exposure apparatus, and reduces the mask cost.

The below will describe an example of a production system for microdevices (semiconductor chips such as ICs and LSIs, liquid-crystal panels, CCDs, thin-film magnetic heads, micromachines, and so on) using an exposure system having a plurality of exposure apparatus. This system utilizes a computer network outside the manufacturing factory, for action to trouble and regular maintenance of the manufacturing apparatus installed in the semiconductor manufacturing factory, or for maintenance services including provision of software.

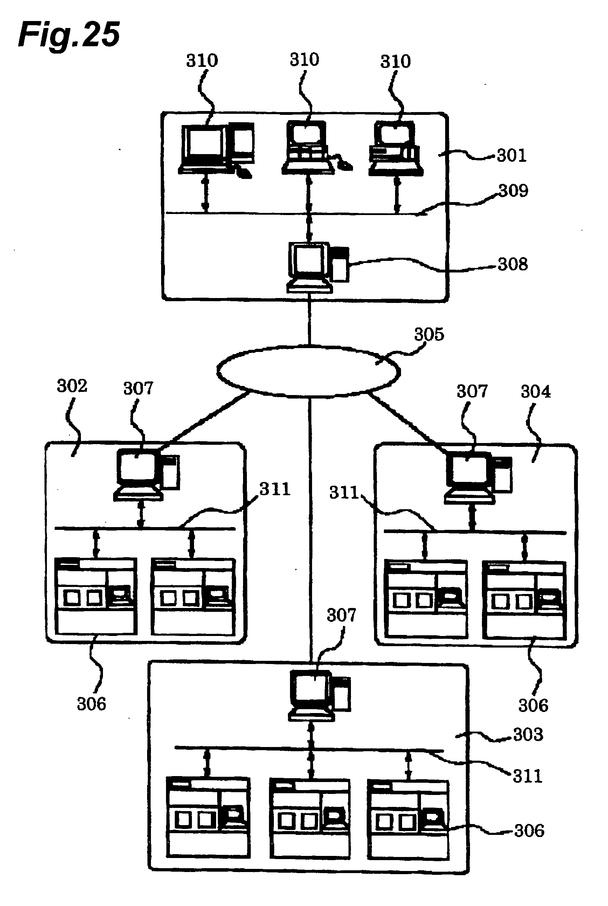

Fig. 25 is a drawing to express an overall system according to the present embodiment as a view from a certain aspect. In the drawing, numeral 301 designates a business establishment of a vendor (apparatus supply maker) for providing manufacturing apparatus of semiconductor devices. Actual examples of the manufacturing apparatus assumed herein include semiconductor manufacturing apparatus for various processes used in semiconductor manufacturing factories; for example, pre-processing equipment (lithography apparatus such as exposure apparatus, resist processing apparatus, and etching apparatus, thermal treatment apparatus, film-forming apparatus, planarization apparatus, etc.), and post-processing equipment (assembling apparatus, inspection apparatus, etc.). In the business establishment 301 there are a host management system 308 for providing a maintenance database of manufacturing apparatus, a plurality of operation terminal computers 310, and a local area network (LAN) 309 constructing an intranet while connecting them. The host management system 308 has a gateway for connecting the LAN 309 to Internet 305 being an external network outside the business establishment, and a security function for limiting access from the outside.

On the other hand, numerals 302 to 304 denote manufacturing factories of semiconductor manufacturing makers as users of manufacturing apparatus. The manufacturing factories 302-304 may be factories belonging to mutually different makers, or may be factories belonging to one maker (e.g., a factory for pre-processing, a factory for post-processing, and so on). In each of the factories 302-304, there are a plurality of manufacturing apparatus 306 including the foregoing exposure system (a plurality of exposure apparatus), a local area network (LAN) 311 constructing an intranet while connecting them, and a host management system 307 as a monitoring device for monitoring operation situations of the respective manufacturing apparatus 306. The host management system 307 provided in each factory 302-304 has a gateway for connecting the LAN 311 in each factory to Internet 305 as an external network outside the factory. This enables access from LAN 311 in each factory through Internet 305 to the host management system 308 on the vendor 301 side, and access is permitted for only limited users by the security function of the host management system 308.

Specifically, each user is permitted to send a notification of status information indicating operation situations of respective manufacturing apparatus 306 (e.g., a symptom of a manufacturing apparatus suffering trouble) from the factory side to the vendor side through the Internet 305, and the user is permitted to receive response information to the notification (e.g., information to indicate how to handle the trouble, and software and data for handling), up-to-date software, and maintenance information such as help information from the vendor side. The communication protocol (TCP/IP) commonly used in the Internet is used for data communication between each factory 302-304 and the vendor 301 and for data communication through LAN 311 in each factory. A dedicated network (e.g., ISDN) with higher security to block access from third parties can also be used instead of the Internet, as an external network outside the factory. The host management system does not have to be limited to that provided by the vendor, but it is also possible to adopt a configuration wherein a user constructs a database and places it on an external network so as to permit access from a plurality of factories of the user to the database.

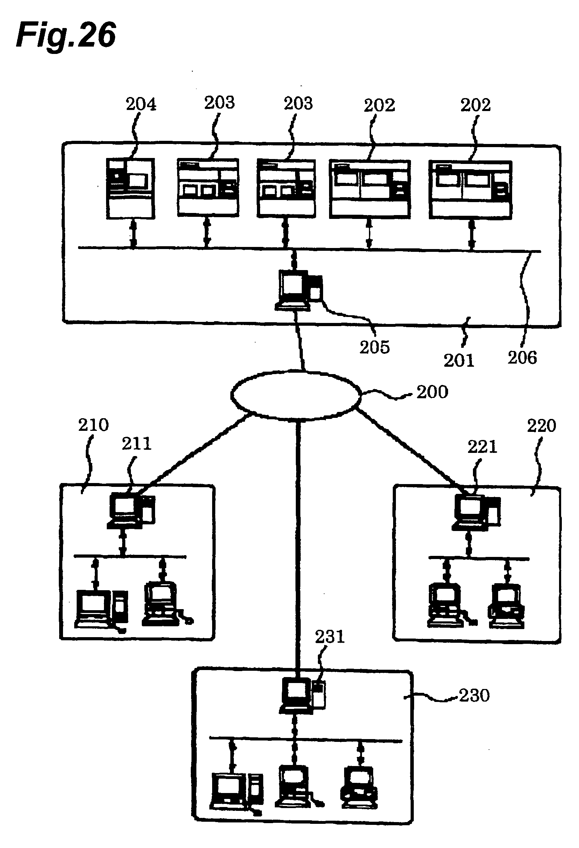

Fig. 26 is a conceptual diagram to express an overall system of the present embodiment as a view from another aspect different from that of Fig. 25. The example of Fig. 25 was the configuration wherein the plurality of user factories each with the manufacturing apparatus were connected through the external network to the management system of the vendor of the manufacturing apparatus and wherein production management of each factory and data communication of information about at least one manufacturing apparatus were performed through the external network. In contrast to it, the present example is a configuration wherein a factory equipped with manufacturing apparatus of plural vendors is connected through an external network outside the factory to management systems of the respective vendors of the manufacturing apparatus and wherein data communication is performed for maintenance information of each manufacturing apparatus. In the drawing, numeral 201 designates a manufacturing factory of a user of manufacturing apparatus (semiconductor device manufacturing maker), and a manufacturing line in the factory is equipped with manufacturing apparatus for various processes, e.g., first and second exposure apparatus 202 in the foregoing embodiment, resist processing apparatus 203, and a film-forming apparatus 204. In Fig. 26 only one manufacturing factory 201 is depicted, but a plurality of factories are networked in similar fashion in fact. The apparatus in the factory are connected through LAN 206 to construct an intranet and the manufacturing line is operated and managed by host management system 205.

On the other hand, each of business establishments of the respective vendors (apparatus supply makers) such as exposure apparatus maker 210, resist processing apparatus maker 220, and film-forming apparatus maker 230 is equipped with a host management system 211, 221, 231 for execution of remote maintenance of equipment supplied by each vendor, and the host management system has a maintenance database and a gateway to the external network as described above. The host management system 205 for managing each of the apparatus in the manufacturing factory of the user is connected through the Internet or a dedicated network as external network 200 to the management systems 211, 221, 231 of the respective apparatus vendors. When in this system a trouble occurs in any one of the sequential manufacturing equipments in the manufacturing line, the operation of the manufacturing line will stop, but the vendor of the equipment with the trouble can perform remote maintenance through the Internet 200 to quickly care for it, thereby minimizing the stop of the manufacturing line.

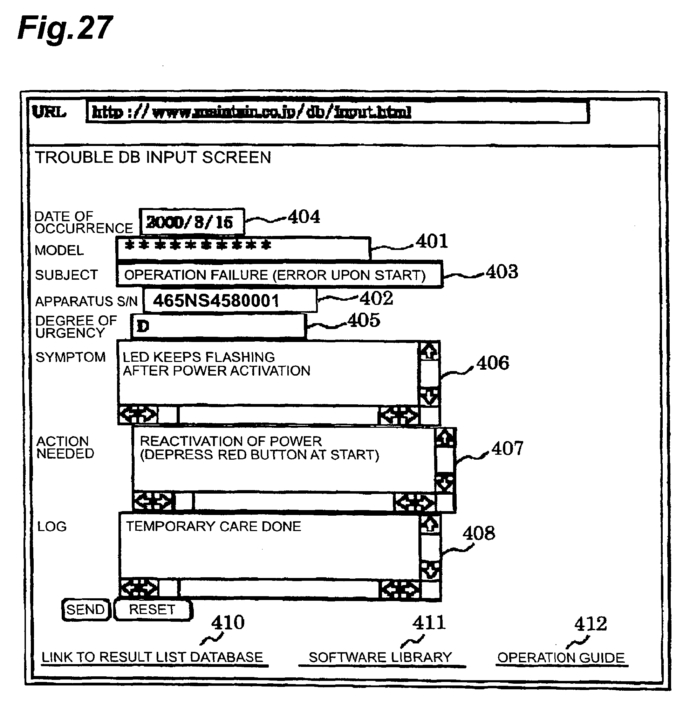

Each of the manufacturing apparatus installed in the semiconductor manufacturing factory is equipped with a display, a network interface, a software application for network access stored in a storage device, and a computer for executing a software application for operation of the apparatus. The storage device can be a built-in memory or hard disk, or a network file server or the like. The aforementioned network access software includes a dedicated or general-purpose web browser, and provides, for example, a user interface of a screen as shown as an example in Fig. 27, on the display.

An operator managing the manufacturing apparatus in each factory enters the following information in respective input items on the screen while browsing the screen: model of manufacturing apparatus (401), serial number (402), name of trouble (403), date of occurrence (404), degree of urgency (405), symptom (406), action needed (407), log (408), and so on. The input information is fed through the Internet to the maintenance database and appropriate maintenance information as a result is fed back from the maintenance database to be presented on the display. The user interface provided by the web browser further provides hyperlink functions (410-412) as illustrated, and thus the operator is allowed to access more detailed information about each of the items, to pull a software application of an up-to-date version to be used in the manufacturing apparatus, from a software library provided by a vendor, and to retrieve an operation guide (help information) for the operator of the factory to refer to.

The foregoing status information may contain the information about the polarization state measured by the polarization measuring section 18 in the foregoing embodiment, and the aforementioned response information may contain the information about the adjustment amounts of the aforementioned variable phase difference members and variable optical rotating members.

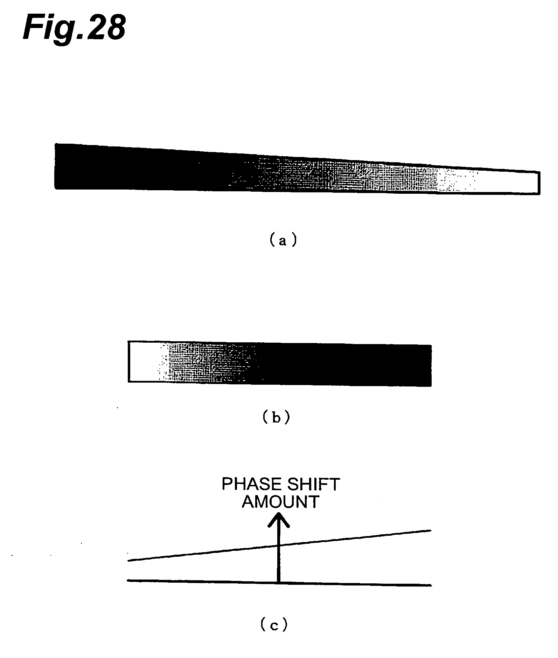

Concerning the aforementioned aspherical optical rotator, where only the linear component (inclination component) of the optical rotation distribution is to be compensated for by this aspherical optical rotator, the optical rotator used may be one of a wedge shape, as shown in Fig. 28 (a). In this configuration, where the wedge angle of the wedge-shaped optical rotator is extremely small (e.g., when it is in the range of 0.5' to 10'), the optical-axis corrector does not always have to be provided.

Concerning the aforementioned aspherical phase shifter, where only the linear component (inclination component) of the phase shift distribution is to be compensated for by this aspherical phase shifter, an optically transparent member having a stress-strain distribution (stress birefringence distribution) of the linear component, as shown in Fig. 28(b), can be used instead of the aspherical phase shifter. A distribution of phase shifts of this optically transparent member shown in Fig. 28 (b) is a phase shift distribution of the linear component (inclination component), as shown in Fig. 28 (c).

For example, even in a case where an optically transparent member making the mask has a birefringence distribution, the adjustment method according to each embodiment described above permits the apparatus to illuminate the mask with illumination light with a polarization distribution capable of compensating for the birefringence distribution inside the mask, and it is thus feasible to correct degradation of polarization states due to the mask and to reduce line-width anomaly of patterns formed on the photosensitive substrate. Even in a case where the projection optical system has a predetermined retardation distribution, the mask can be illuminated with illumination light with a polarization distribution capable of compensating for this retardation distribution, and it is thus feasible to correct degradation of polarization states due to the projection optical system and to reduce line-width anomaly of patterns formed on the photosensitive substrate.

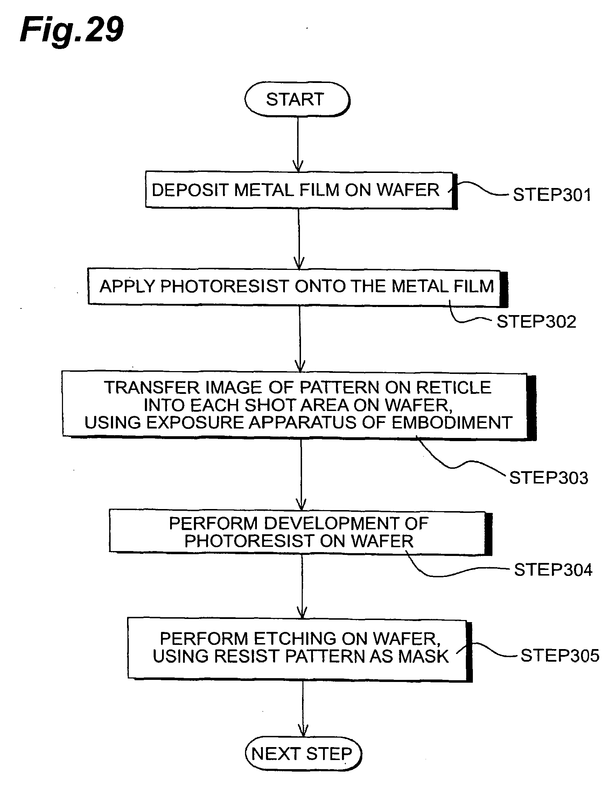

The exposure apparatus of the foregoing embodiment can be used to manufacture microdevices (semiconductor devices, image pickup devices, liquid-crystal display devices, thin-film magnetic heads, etc.) by illuminating a mask (reticle) by the illumination optical apparatus (illumination step) and projecting a pattern to be transferred, formed in the mask, onto a photosensitive substrate with the projection optical system (exposure step). An example of a technique of forming a predetermined circuit pattern in a wafer or the like as a photosensitive substrate with the exposure apparatus of the foregoing embodiment to obtain semiconductor devices as microdevices will be described below with reference to the flowchart of Fig. 29.

The first step 301 in Fig. 29 is to deposit a metal film on each wafer in one lot. The next step 302 is to apply a photoresist onto the metal film on each wafer in the lot. The subsequent step 303 is to sequentially transfer an image of a pattern on the mask into each shot area on each wafer in the lot through the projection optical system, using the exposure apparatus of the foregoing embodiment. The subsequent step 304 is to perform development of the photoresist on each wafer in the lot and the subsequent step 305 is to perform etching on each wafer in the lot, using the resist pattern as a mask, and thereby to form a circuit pattern corresponding to the pattern on the mask, in each shot area on each wafer. Subsequent steps include formation of circuit patterns in upper layers, and others, thereby manufacturing devices such as semiconductor devices. The above-described method of manufacturing semiconductor device permits us to obtain semiconductor devices with extremely fine circuit patterns at high throughput.

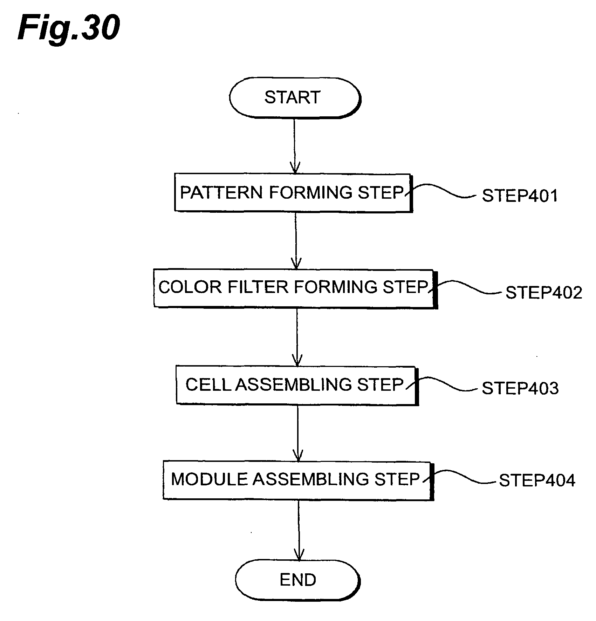

The exposure apparatus of the foregoing embodiment can also be used to manufacture a liquid-crystal display device as a microdevice by forming predetermined patterns (circuit pattern, electrode pattern, etc.) on plates (glass substrates). An example of a technique in this case will be described with reference to the flowchart of Fig. 30. In Fig. 30, a pattern forming step 401 is to execute a so-called photolithography step to transfer a pattern of a mask onto a photosensitive substrate (glass substrate coated with a resist, or the like) with the exposure apparatus of the foregoing embodiment. This photolithography step results in forming the predetermined pattern including a number of electrodes and others on the photosensitive substrate. Thereafter, the exposed substrate is subjected to each of steps such as development, etching, and resist removal, whereby a predetermined pattern is formed on the substrate. Thereafter, the process shifts to the next color filter forming step 402.

The next color filter forming step 402 is to form a color filter in which a number of sets of three dots corresponding to R (Red), G (Green), and B (Blue) are arrayed in a matrix pattern, or in which sets of three stripe filters of R, G, and B are arrayed as a plurality of lines along the horizontal scan line direction. After completion of the color filter forming step 402, a cell assembling step 403 is carried out. The cell assembling step 403 is to assemble a liquid crystal panel (liquid crystal cell), using the substrate with the predetermined pattern obtained in the pattern forming step 401, the color filter obtained in the color filter forming step 402, and so on.

In the cell assembling step 403, for example, a liquid crystal is poured into between the substrate with the predetermined pattern obtained in the pattern forming step 401 and the color filter obtained in the color filter forming step 402, to manufacture a liquid crystal panel (liquid crystal cell). The subsequent module assembling step 404 is to install each of components such as an electric circuit, a backlight, etc. for display operation of the assembled liquid crystal panel (liquid crystal cell) to complete the liquid-crystal display device. The above-described method of manufacturing the liquid-crystal display device permits us to obtain the liquid-crystal display device with an extremely fine circuit pattern at high throughput.

In the foregoing embodiment the exposure light was the ArF excimer laser light (wavelength: 193 nm) or the KrF excimer laser light (wavelength: 248 nm), but, without having to be limited to these, the present invention can also be applied to the other appropriate laser light sources, e.g., an $F_2$ laser light source for supplying laser light of wavelength of 157 nm.

In the foregoing embodiment the present invention was applied to the illumination optical apparatus for illuminating the mask in the exposure apparatus, but the present invention is not limited to this example and is also applicable to ordinary illumination optical apparatus for illuminating a surface to be illuminated, except for masks, and to adjustment methods thereof.

Description of Reference Symbols

1 light source
3, 4 variable phase difference members
5 depolarizer
6 diffractive optical element
7 afocal lens
9, 19 variable phase difference units
10 conical axicon system
11 zoom lens
12 variable optical rotator unit
13 micro fly's eye lens
14 polarization monitor
15 condenser optical system
16 mask blind
17 imaging optical system
18 polarization state measuring section M mask
PL projection optical system
W wafer

**Claims**

1. An illumination optical system for illuminating a surface to be illuminated,
   the illumination optical system comprising a polarization converting element (9, 12) located on or near an illumination pupil plane and adapted for converting a polarization state of incident light into a predetermined polarization state, wherein the polarization converting element (9, 12) is adapted to locally change a polarization state of light at a position on or near the pupil plane of the illumination optical system, and
   **characterized in that** the polarization converting element (12) has a plurality of variable optical rotating members (12a-h) for variably yielding a polarization rotation angle to incident linearly polarized light.

2. An illumination optical system for illuminating a surface to be illuminated, the illumination optical system comprising:

   a polarization converting element (12, 19) located near the surface to be illuminated, at a position optically conjugate with the surface to be illuminated, or near the conjugate position and adapted for converting a polarization state of incident light into a predetermined polarization state,
   wherein the polarization converting element is adapted to locally change a polarization state of illumination light on the surface to be illuminated, and
   **characterized in that** the polarization converting element (12) has a plurality of variable optical rotating members (12a-h) for variably yielding a polarization rotation angle to incident linearly polarized light.

3. An illumination optical system according to claim 1 or 2, wherein each of the plurality of variable optical rotating members (12ah) has two deviation prisms (23a, b) made of an optical material with an optical activity and arranged to be movable relative to each other along a direction intersecting with the optical axis of the illumination optical system.

4. An illumination optical system according to claim 3, wherein the two deviation prisms (23a, b) are arranged so that crystallographic axes thereof are substantially parallel to the optical axis (AX).

5. An illumination optical system according to claim 4, wherein the two deviation prisms (23 a, b) are formed so that a difference between a thickness of one deviation prism and a thickness of the other deviation prism along a line parallel to the optical axis is different from that along at least one line among other lines parallel to the optical axis.

6. An illumination optical system according to claim 3, 4 or 5, wherein the two deviation prisms (23a, b) have their respective wedge-shaped cross sections complementary to each other.

7. An illumination optical system according to any one of claims 1 to 6, wherein the plurality of variable optical rotating members (12a-h) are arranged along a circumferential direction of a circle centered around the optical axis (AX) of the illumination optical system.

8. An illumination optical system according to claim 7, wherein each of the plurality of variable optical rotating members (12ah) has a substantially sectorial shape.

9. An illumination optical system according to any one of claims 1 to 8, further comprising a polarization state measuring device (18) for measuring a polarization state of light reaching the surface to be illuminated,
wherein each of the plurality of variable optical rotating members (12a-h) is adjusted according to a result of measurement by the polarization state measuring device (18).

10. An illumination optical system according to any one of claims 1 to 9, wherein the polarization converting element (9, 19, 61-66) has a plurality of variable phase difference members (9a-h, 19a-e, 61-66) for variably yielding a phase difference between incident light and emerging light.

11. An illumination optical system according to claim 10, wherein each of the plurality of variable phase difference members (9ah, 19a-e, 61-66) has a Babinet compensator (22a, b) or a Soleil compensator (21 a, b, c) rotatably arranged around an axis substantially parallel to the optical axis (AX) of the illumination optical system.

12. An illumination optical system according to claim 11, wherein the plurality of variable phase difference members (9a,h, 61-66) are arranged corresponding to respective regions on the pupil plane and each of which can adjust a phase change of a passing light beam.

13. An illumination optical system according to claim 10 or 12, wherein the plurality of variable phase difference members (9a-h) are arranged along a circumferential direction of a circle centered around the optical axis of the illumination optical system.

14. An illumination optical system according to claim 10 or 12, if dependent on claim 2, wherein the plurality of variable phase difference members (19a-e) are arranged in a rectangular region centered around the optical axis AX.

15. An illumination optical system according to any one of claims 10 to 14, further comprising a polarization state measuring device (18) for measuring a polarization state of light reaching the surface to be illuminated,
wherein each of the plurality of variable phase difference members (9a-h, 19a-e) is adjusted according to a result of measurement by the polarization state measuring device (18).

16. An illumination optical system according to claim 9 or 15, wherein the polarization state measuring device (18) is adapted to measure a polarization state distribution at the position of the pupil plane.

17. An illumination optical system according to claim 9, 15 or 16, wherein the polarization state measuring device (18) is adapted to measure the distribution of polarization states at a plurality of positions at the surface to be illuminated.

18. An illumination optical system according to any one of claims 1 and 3 to 17 if not dependent on claim 2, comprising another polarization converting element (19) located near the surface to be illuminated, at a position optically conjugate with the surface to be illuminated, or near the conjugate position and adapted for converting a polarization state of incident light into a predetermined polarization state,
wherein the other polarization converting element is adapted to locally change a polarization state of illumination light on the surface to be illuminated.

19. An illumination optical system according to any one of claims 1 to 18, the illumination optical system further comprising an optical integrator (13);
wherein the polarization converting element (9) is located in an incident side optical path of the optical integrator (13).

20. An illumination optical system according to claim 2,
wherein the polarization converting element (19) has a plurality of variable phase difference members (19a-e) for variably yielding a phase difference between incident light and emerging light,
wherein the plurality of variable optical rotating members (12ah) are located in an incident side optical path of the plurality of variable phase difference members (19a-e).

21. An illumination optical system according to claim 20, further comprising a relay optical system (7b, 11) located between the plurality of variable phase difference members (9a-h, 19a-e) and the plurality of variable optical rotating members (12a-h).

22. An illumination optical system according to any one of claims 1 to 21, wherein the polarization converting element (9, 12, 19) comprises a variable phase shifter for adjusting an ellipticity of incident light (61-66).

23. An exposure apparatus comprising the illumination optical system as defined in any one of claims 1 to 22, adapted to project a predetermined pattern illuminated by the illumination optical system onto a photosensitive substrate as the surface to be illuminated to effect exposure thereof.

24. A method of manufacturing a device comprising:

an exposure step of projecting a predetermined pattern onto a photosensitive substrate to effect exposure thereof, using the exposure apparatus as defined in claim 22 ; and
a development step of developing the photosensitive substrate exposed in the exposure step.

**Patentansprüche**

1. Optisches Beleuchtungssystem zum Beleuchten einer zu beleuchtenden Oberfläche,
das optische Beleuchtungssystem mit einem Polarisationsumwandlungselement (9, 12), das an oder nahe zu einer Beleuchtungspupillenebene angeordnet ist und zum Umwandeln eines Polarisationszustands von einfallendem Licht in einen vorher festgelegten Polarisationszustand ausgestaltet ist,
wobei das Polarisationsumwandlungselement (9, 12) dazu ausgestaltet ist, lokal einen Polarisationszustand von Licht an einer Position an oder nahe zu der Pupillenebene der optischen Beleuchtungssystems zu verändern, und **dadurch gekennzeichnet, dass** das
Polarisationsumwandlungselement (12) mehrere variable optische Drehelemente (12a-h) aufweist, um variabel einen Polarisationsdrehwinkel für einfallendes linear polarisiertes Licht bereitzustellen.

2. Optisches Beleuchtungssystem zum Beleuchten einer zu beleuchtenden Oberfläche, das optische Beleuchtungssystem mit:

einem Polarisationsumwandlungselement (12, 19), das nahe der zu beleuchtenden Oberfläche angeordnet ist, an einer Position optisch konjugiert zur zu beleuchtenden Oberfläche, oder nahe der konjugierten Position und dazu ausgestaltet, einen Polarisationszustand von einfallendem Licht in einen vorher festgelegten Polarisationszustand umzuwandeln,
wobei das Polarisationsumwandlungselement (9, 12) dazu ausgestaltet ist, lokal einen Polarisationszustand von Beleuchtungslicht auf der zu beleuchtenden Oberfläche zu verändern, und **dadurch gekennzeichnet, dass** das Polarisationsumwandlungselement (12) mehrere variable optische Drehelemente (12a-h) aufweist, um variabel einen Polarisationsdrehwinkel für einfallendes linear polarisiertes Licht bereitzustellen.

**3.** Optisches Beleuchtungssystem nach Anspruch 1 oder 2, wobei jedes der mehreren variablen optischen Drehelemente (12a-h) zwei Ablenkprismen (23a, b) aufweist, die aus einem optischen Material mit einer optischen Aktivität gemacht sind und die dazu ausgestaltet sind, zueinander entlang einer Richtung beweglich zu sein, welche die optische Achse des optischen Beleuchtungssystems schneidet.

**4.** Optisches Beleuchtungssystem nach Anspruch 3, wobei die zwei Ablenkprismen (23a, b) so angeordnet sind, dass deren kristallographische Achsen im Wesentlichen parallel zur optischen Achse (AX) sind.

**5.** Optisches Beleuchtungssystem nach Anspruch 4, wobei die zwei Ablenkprismen (23a, b) so ausgebildet sind, dass eine Differenz zwischen einer Dicke von einem der Ablenkprismen und einer Dicke des anderen Ablenkprismas entlang einer Linie parallel zur optischen Achse verschieden von der entlang wenigstens einer Line unter anderen Linien ist, die parallel zur optischen Achse sind.

**6.** Optisches Beleuchtungssystem nach Anspruch 3, 4 oder 5, wobei die zwei Ablenkprismen (23a, b) ihre jeweiligen keilförmigen Querschnitte komplementär zueinander haben.

**7.** Optisches Beleuchtungssystem nach einem der Ansprüche 1 bis 6, wobei die mehreren variablen optischen Drehelemente (12a-h) entlang einer Umfangsrichtung eines Kreises angeordnet sind, der um die optische Achse (AX) des optischen Beleuchtungssystems zentriert ist.

**8.** Optisches Beleuchtungssystem nach Anspruch 7, wobei jedes der variablen optischen Drehelemente (12a-h) im Wesentlichen eine Sektorform aufweist.

**9.** Optisches Beleuchtungssystem nach einem der Ansprüche 1 bis 8, ferner mit einer Messeinrichtung (18) für den Polarisationszustand zum Messen eines Polarisationszustands von Licht, das die zu beleuchtende Oberfläche erreicht,
wobei jedes der variablen optischen Drehelemente (12a-h) gemäß einem Messergebnis von der Messeinrichtung (18) für den Polarisationszustand angepasst wird.

**10.** Optisches Beleuchtungssystem nach einem der Ansprüche 1 bis 9, wobei das Polarisationsumwandlungselement (9, 19, 61-66) mehrere variable Phasendifferenzelemente (9a-h, 19a-e, 61-66) aufweist, um variabel eine Phasendifferenz zwischen einfallendem Licht und austretendem Licht bereitzustellen.

**11.** Optisches Beleuchtungssystem nach Anspruch 10, wobei jedes der mehreren variablen Phasendifferenzelemente (9a-h, 19a-e, 61-66) einen Babinet-Kompensator (9a-h, 19a-e, 61-66) oder einen Soleil-Kompensator (21a,b,c) aufweist, der drehbar um eine Achse im Wesentlichen parallel zur optischen Achse (AX) des optischen Beleuchtungssystems angeordnet ist.

**12.** Optisches Beleuchtungssystem nach Anspruch 11, wobei die mehreren variablen Phasendifferenzelemente (9a,h, 61-66) entsprechend jeweiligen Bereichen auf der Pupillenebene angeordnet sind und wobei jedes von ihnen eine Phasenveränderung eines durchtretenden Lichtstrahls anpassen kann.

**13.** Optisches Beleuchtungssystem nach Anspruch 10 oder 12, wobei die mehreren variablen Phasendifferenzelemente (9a-h) entlang einer Umfangsrichtung eines Kreises angeordnet sind, der um die optische Achse des optischen Beleuchtungssystems zentriert ist.

**14.** Optisches Beleuchtungssystem nach Anspruch 10 oder 12, wenn von Anspruch 2 abhängig, wobei die mehreren variablen Phasendifferenzelemente (19a-e) in einem rechteckigen Bereich angeordnet sind, der um die optische Achse AX zentriert ist.

**15.** Optisches Beleuchtungssystem nach einem der Ansprüche 10 bis 14, ferner mit einer Messeinrichtung (18) für den Polarisationszustand, um einen Polarisationszustand von Licht zu messen, welches die zu beleuchtende Oberfläche erreicht,
wobei jedes der mehreren variablen
Phasendifferenzelemente (9a-h, 19a-e) gemäß einem Messergebnis der Messeinrichtung (18) für den Polarisationszustand angepasst wird.

**16.** Optisches Beleuchtungssystem nach Anspruch 9 oder 15, wobei die Messeinrichtung (18) für den Polarisationszustand dazu ausgestaltet ist, eine Polarisationszustandsverteilung an der Position der Pupillenebene zu messen.

17. Optisches Beleuchtungssystem nach Anspruch 9, 15 oder 16, wobei die Messeinrichtung (18) für den Polarisationszustand dazu ausgestaltet ist, die Verteilung der Polarisationszustände an mehreren Positionen an der zu beleuchtenden Oberfläche zu messen.

18. Optisches Beleuchtungssystem nach einem der Ansprüche 1 und 3 bis 17, wenn nicht von Anspruch 2 abhängig, mit einem anderen Polarisationsumwandlungselement (19), das nahe der zu beleuchtenden Oberfläche angeordnet ist an einer Position, die zu der zu beleuchtenden Oberfläche konjugiert ist, oder nahe der konjugierten Position und dazu ausgestaltet, einen Polarisationszustand von einfallendem Licht in einen vorher festgelegten Polarisationszustand umzuwandeln,
wobei das Polarisationsumwandlungselement dazu ausgestaltet ist, lokal einen Polarisationszustand von Beleuchtungslicht auf der zu beleuchtenden Oberfläche zu verändern.

19. Optisches Beleuchtungssystem nach einem der Ansprüche 1 bis 18, das optische Beleuchtungssystem ferner mit einem optischen Integrator (13),
wobei das Polarisationsumwandlungselement (9) in einem einfallseitigen optischen Weg des optischen Integrators (13) angeordnet ist.

20. Optisches Beleuchtungssystem nach Anspruch 2,
wobei das Polarisationsumwandlungselement (19) mehrere variable Phasendifferenzelemente (19a-e) aufweist, um variabel eine Phasendifferenz zwischen einfallendem Licht und austretendem Licht bereitzustellen,
wobei die mehreren variablen optischen Drehelemente (12a-h) in einem einfallseitigen optischen Weg der mehreren variablen Phasendifferenzelemente (19a-e) angeordnet sind.

21. Optisches Beleuchtungssystem nach Anspruch 20, ferner mit einem optischen Übertragungssystem (7b, 11), das zwischen den mehreren variablen Phasendifferenzelementen (9a-h, 19a-e) und den mehreren variablen optischen Drehelementen (12a-h) angeordnet ist.

22. Optisches Beleuchtungssystem nach einem der Ansprüche 1 bis 21, wobei das Polarisationsumwandlungselement (9, 12, 19) einen variablen Phasenveränderer zum Anpassen der Elliptizität von einfallendem Licht (61-66) aufweist.

23. Belichtungsvorrichtung mit dem optischen Beleuchtungssystem nach einem der Ansprüche 1 bis 22, die dazu ausgestaltet ist, ein vorher festgelegtes Muster, das durch das optische Beleuchtungssystem beleuchtet wird, auf ein lichtempfindliches Substrat als zu beleuchtende Oberfläche zu projizieren, um eine Belichtung von diesem zu erzielen.

24. Verfahren zum Herstellen einer Einrichtung mit:

einem Belichtungsschritt des Projizierens eines vorher festgelegten Musters auf ein lichtempfindliches Substrat, um eine Belichtung von diesem zu erzielen, unter Verwendung der Belichtungsvorrichtung nach Anspruch 22, und
einem Entwickelschritt des Entwickelns des lichtempfindlichen Substrats, das in dem Belichtungsschritt belichtet wurde.

**Revendications**

1. Système optique d'éclairage pour éclairer une surface à éclairer,
le système optique d'éclairage comprenant un élément de conversion de polarisation (9, 12) situé sur un plan pupillaire d'éclairage, ou à proximité de celui-ci, et adapté pour convertir un état de polarisation de lumière incidente en un état de polarisation prédéterminé,
dans lequel l'élément de conversion de polarisation (9, 12) est adapté pour changer localement un état de polarisation de lumière dans une position sur le plan pupillaire du système optique d'éclairage, ou à proximité de celui-ci, et
**caractérisé en ce que** l'élément de conversion de polarisation (12) présente une pluralité d'éléments optiques rotatifs variables (12a-h) pour fournir de manière variable un angle de rotation de polarisation à une lumière linéairement polarisée incidente.

**2.** Système optique d'éclairage pour éclairer une surface à éclairer, le système optique d'éclairage comprenant :

un élément de conversion de polarisation (12, 19) situé à proximité de la surface à éclairer, dans une position optiquement conjuguée à la surface à éclairer, ou à proximité de la position conjuguée, et adapté pour convertir un état de polarisation de lumière incidente en un état de polarisation prédéterminé,
dans lequel l'élément de conversion de polarisation est adapté pour changer localement un état de polarisation de lumière d'éclairage sur la surface à éclairer, et
**caractérisé en ce que** l'élément de conversion de polarisation (12) présente une pluralité d'éléments optiques rotatifs variables (12a-h) pour fournir de manière variable un angle de rotation de polarisation à une lumière linéairement polarisée incidente.

**3.** Système optique d'éclairage selon la revendication 1 ou 2, dans lequel chacun de la pluralité d'éléments optiques rotatifs variables (12a-h) présente deux prismes de déviation (23a, b) constitués d'un matériau optique avec une activité optique, et agencés pour être mobiles l'un par rapport à l'autre le long d'une direction coupant l'axe optique du système optique d'éclairage.

**4.** Système optique d'éclairage selon la revendication 3, dans lequel les deux prismes de déviation (23a, b) sont agencés de sorte que leurs axes cristallographiques soient sensiblement parallèles à l'axe optique (AX).

**5.** Système optique d'éclairage selon la revendication 4, dans lequel les deux prismes de déviation (23a, b) sont formés de sorte qu'une différence entre une épaisseur d'un prisme de déviation et une épaisseur de l'autre prisme de déviation le long d'une ligne parallèle à l'axe optique soit différente de celle le long d'au moins une ligne parmi d'autres lignes parallèles à l'axe optique.

**6.** Système optique d'éclairage selon la revendication 3,4 ou 5, dans lequel les deux prismes de déviation (23a, b) ont leurs sections transversales respectives en forme de cale qui sont complémentaires l'une à l'autre.

**7.** Système optique d'éclairage selon l'une quelconque des revendications 1 à 6, dans lequel la pluralité d'éléments optiques rotatifs variables (12a-h) sont agencés le long d'une direction circonférentielle centrée autour de l'axe optique (AX) du système optique d'éclairage.

**8.** Système optique d'éclairage selon la revendication 7, dans lequel chacun de la pluralité d'éléments optiques rotatifs variables (12a-h) a une forme sensiblement en secteur.

**9.** Système optique d'éclairage selon l'une quelconque des revendications 1 à 8, comprenant en outre un dispositif de mesure d'état de polarisation (18) pour mesurer un état de polarisation d'une lumière atteignant la surface à éclairer, dans lequel chacun de la pluralité d'éléments optiques rotatifs variables (12a, h) est ajusté selon un résultat de mesure par le dispositif de mesure d'état de polarisation (18).

**10.** Système optique d'éclairage selon l'une quelconque des revendications 1 à 9, dans lequel l'élément de conversion de polarisation (9, 19, 61-66) présente une pluralité d'éléments de différence de phase variables (9a-h, 19a-e, 61-66) pour obtenir de manière variable une différence de phase entre une lumière incidente et une lumière émergente.

**11.** Système optique d'éclairage selon la revendication 10, dans lequel chacun de la pluralité d'éléments de différence de phase variables (9a-h, 19a-e, 61-66) présentent un compensateur de Babinet (22a, b) ou un compensateur de Soleil (21a, b, c) agencé à rotation autour d'un axe sensiblement parallèle à l'axe optique (AX) du système optique d'éclairage.

**12.** Système optique d'éclairage selon la revendication 11, dans lequel la pluralité d'éléments de différence de phase variables (9a, h, 61-66) sont agencés en correspondance avec des régions respectives du plan pupillaire, chacun pouvant régler un changement de phase d'un faisceau de lumière passant.

**13.** Système optique d'éclairage selon la revendication 10 ou 12, dans lequel la pluralité d'éléments de différence de phase variables (9a-h) sont agencés le long d'une direction circonférentielle d'un cercle centré autour de l'axe optique du système optique d'éclairage.

**14.** Système optique d'éclairage selon la revendication 10 ou 12 si elles dépendent de la revendication 2, dans lequel la pluralité d'éléments de différence de phase variables (19a, e) sont agencés dans une région rectangulaire centrée autour de l'axe optique AX.

**15.** Système optique d'éclairage selon l'une quelconque des revendications 10 à 14, comprenant en outre un dispositif de mesure d'état de polarisation (18) pour mesurer un état de polarisation d'une lumière atteignant la surface à éclairer, dans lequel chacun de la pluralité d'éléments de différence de phase variables (9a-h, 19a-e) est ajusté selon un résultat de mesure par le dispositif de mesure d'état de polarisation (18).

**16.** Système optique d'éclairage selon la revendication 9 ou 15, dans lequel le dispositif de mesure d'état de polarisation (18) est adapté pour mesurer une distribution d'état de polarisation dans la position du plan pupillaire.

**17.** Système optique d'éclairage selon la revendication 9,15 ou 16, dans lequel le dispositif de mesure d'état de polarisation (18) est adapté pour mesurer la distribution d'états de polarisation dans une pluralité de positions sur la surface à éclairer.

**18.** Système optique d'éclairage selon l'une quelconque des revendications 1 et 3 à 17, si elles ne dépendent pas de la revendication 2, comprenant un autre élément de conversion de polarisation (19) situé à proximité de la surface à éclairer, dans une position optiquement conjuguée à la surface à éclairer, ou à proximité de la position conjuguée, et adapté pour convertir un état de polarisation de lumière incidente en un état de polarisation prédéterminé, dans lequel l'autre élément de conversion de polarisation est adapté pour changer localement un état de polarisation de lumière d'éclairage sur la surface à éclairer.

**19.** Système optique d'éclairage selon l'une quelconque des revendications 1 à 18, le système optique d'éclairage comprenant en outre un intégrateur optique (13) ; dans lequel l'élément de conversion de polarisation (9) est situé sur un trajet optique côté incident de l'intégrateur optique (13).

**20.** Système optique d'éclairage selon la revendication 2,
dans lequel l'élément de conversion de polarisation (19) présente une pluralité d'éléments de différence de phase variables (19a-e) pour obtenir de manière variable une différence de phase entre une lumière incidente et une lumière émergente,
dans lequel la pluralité d'éléments optiques rotatifs variables (12a-h) sont situés dans un trajet optique côté incident de la pluralité d'éléments de différence de phase variables (19a-e).

**21.** Système optique d'éclairage selon la revendication 20, comprenant en outre un système optique de relais (7b, 11) situé entre la pluralité d'éléments de différence de phase variables (9a-h, 19a-e) et la pluralité d'éléments optiques rotatifs variables (12a-h).

**22.** Système optique d'éclairage selon l'une quelconque des revendications 1 à 21, dans lequel l'élément de conversion de polarisation (9, 12, 19) comprend un décaleur de phase variable pour ajuster une ellipticité de lumière incidente (61-66).

**23.** Appareil d'exposition comprenant le système optique d'éclairage selon l'une quelconque des revendications 1 à 22, adapté pour projeter un motif prédéterminé éclairé par le système optique d'éclairage sur un substrat photosensible comme surface à éclairer pour effectuer son exposition.

**24.** Procédé de fabrication d'un dispositif, comprenant :

une étape d'exposition visant à projeter un motif prédéterminé sur un substrat photosensible pour effectuer son exposition en utilisant l'appareil d'exposition selon la revendication 22 ; et
une étape de développement pour développer le substrat photosensible exposé à l'étape d'exposition.

*Fig.1*

EP 1 840 945 B1

## Fig.2

# Fig.3

(a)

(b)

**Fig.4**

EP 1 840 945 B1

# Fig.5

## *Fig.6*

(a)

12a~12h

23a
23b

Y

(b)

12a~12h

23a

23b

Y

# Fig.7

# *Fig.8*

**Fig.9**

# Fig.10

9

9a

9h

9b

9g

• AX

9c

9f

9d

9e

Z

Y⊗ ⟶ X

# Fig.11

# Fig.12

(a)

CR

FROM 18 →

DR4

(b)

19a 19b 19c 19d 19e

·AX

19

Z

Y⊗ →X

## Fig.13

34

AX

Z

Y⊗ ⟶ X

# Fig.14

# Fig.15

82f 85f 16

81f

X ⊙ ───▶ Z

Y

# *Fig.16*

(a)

(b)

(c)

*Fig.17*

(a)

(b)

# *Fig.18*

# Fig.19

OPTICAL ROTATION
AMOUNT

Y-DIRECTIONAL
POSITION

(a)

OPTICAL ROTATION
AMOUNT

Y-DIRECTIONAL
POSITION

(b)

PHASE SHIFT
AMOUNT

Y-DIRECTIONAL
POSITION

(c)

PHASE SHIFT
AMOUNT

Y-DIRECTIONAL
POSITION

(d)

# Fig.20

OPTICAL ROTATION
AMOUNT

Y-DIRECTIONAL
POSITION

(a)

OPTICAL ROTATION
AMOUNT

Y-DIRECTIONAL
POSITION

(b)

PHASE SHIFT
AMOUNT

Y-DIRECTIONAL
POSITION

(c)

PHASE SHIFT
AMOUNT

Y-DIRECTIONAL
POSITION

(d)

## Fig.21

# *Fig.22*

(a)

(b)

(c)

# Fig.23

START

CALCULATE OR MEASURE
POLARIZATION STATE
DISTRIBUTION AND PUPIL
POLARIZATION STATE
DISTRIBUTION — S11

S12

ARE
TWO DISTRIBUTIONS
ALMOST UNIFORM
?

YES

NO

DESIGN ASPHERICAL
ROTATORS
(PHASE SHIFTERS) — S13

CALCULATE POLARIZATION
STATE DISTRIBUTION AND
PUPIL POLARIZATION STATE
DISTRIBUTION AFTER MOUNTING
OF ASPHERICAL ROTATORS
(PHASE SHIFTERS) — S14

DETERMINE SHAPES OF
ASPHERICAL ROTATORS
(PHASE SHIFTERS) — S15

MANUFACTURE AND
MOUNT ASPHERICAL
ROTATORS
(PHASE SHIFTERS) — S16

END

# Fig.24

START

CALCULATE OR MEASURE POLARIZATION STATE DISTRIBUTION AND PUPIL POLARIZATION STATE DISTRIBUTION — S21

ARE TWO DISTRIBUTIONS ALMOST UNIFORM ? — S22

YES

DETERMINE SHAPES OF ASPHERICAL ROTATORS (PHASE SHIFTERS) — S27

MANUFACTURE AND MOUNT ASPHERICAL ROTATORS (PHASE SHIFTERS) — S28

END

NO

APPROXIMATE PUPIL POLARIZATION STATE DISTRIBUTION BY FUNCTION OF PUPIL COORDINATES — S23

EVALUATE PUPIL POLARIZATION STATE DISTRIBUTION AS FUNCTION OF IMAGE PLANE COORDINATES AND PUPIL COORDINATES — S24

DESIGN ASPHERICAL ROTATORS (PHASE SHIFTERS) BASED ON OPTIMIZATION METHOD BY LINEAR COUPLING — S25

CALCULATE POLARIZATION STATE DISTRIBUTION AND PUPIL POLARIZATION STATE DISTRIBUTION AFTER MOUNTING OF ASPHERICAL ROTATORS (PHASE SHIFTERS) — S26

TABLE INDICATING RELATION BETWEEN ROTATION (PHASE SHIFT)DISTRIBUTION AND CHANGE IN POLARIZATION STATE DISTRIBUTION — T22

TABLE INDICATING RELATION BETWEEN ROTATION (PHASE SHIFT) DISTRIBUTION AND CHANGE IN PUPIL POLARIZATION STATE DISTRIBUTION — T21

## Fig.25

# Fig.26

# Fig.27

| | |
|---|---|
| **URL** | http://www.maintain.co.jp/db/input.html |

**TROUBLE DB INPUT SCREEN**

DATE OF OCCURRENCE `2000/3/15` ~404

MODEL `* * * * * * * * *` ~401

SUBJECT `OPERATION FAILURE (ERROR UPON START)` ~403

APPARATUS S/N `465NS4580001` ~402

DEGREE OF URGENCY `D` ~405

SYMPTOM `LED KEEPS FLASHING AFTER POWER ACTIVATION` ~406

ACTION NEEDED `REACTIVATION OF POWER (DEPRESS RED BUTTON AT START)` ~407

LOG `TEMPORARY CARE DONE` ~408

[SEND] [RESET]

410 411 412

LINK TO RESULT LIST DATABASE  SOFTWARE LIBRARY  OPERATION GUIDE

# Fig.28

(a)

(b)

PHASE SHIFT
AMOUNT

(c)

# Fig.29

```
                    ( START )
                        │
                        ▼
        ┌─────────────────────────────────┐
        │  DEPOSIT METAL FILM ON WAFER     │ ── STEP301
        └─────────────────────────────────┘
                        │
                        ▼
        ┌─────────────────────────────────┐
        │  APPLY PHOTORESIST ONTO THE METAL FILM │
        └─────────────────────────────────┘ ── STEP302
                        │
                        ▼
        ┌─────────────────────────────────┐
        │  TRANSFER IMAGE OF PATTERN ON RETICLE │
        │    INTO EACH SHOT AREA ON WAFER,  │
        │ USING EXPOSURE APPARATUS OF EMBODIMENT │
        └─────────────────────────────────┘
                                         ── STEP303
                        │
                        ▼
        ┌─────────────────────────────────┐
        │    PERFORM DEVELOPMENT OF         │
        │      PHOTORESIST ON WAFER         │
        └─────────────────────────────────┘ ── STEP304
                        │
                        ▼
        ┌─────────────────────────────────┐
        │    PERFORM ETCHING ON WAFER,      │ ── STEP305
        │  USING RESIST PATTERN AS MASK     │
        └─────────────────────────────────┘
                        │
                        ▼
                  ( NEXT STEP )
```

# Fig.30

START

PATTERN FORMING STEP — STEP401

COLOR FILTER FORMING STEP — STEP402

CELL ASSEMBLING STEP — STEP403

MODULE ASSEMBLING STEP — STEP404

END

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004051717 A
- EP 1260849 A1
- US 5933219 A
- WO 2005076045 A
- US 6870668 B
- US 20030206289 A
- JP 2005012190 A

**Non-patent literature cited in the description**

- **TSURUTA.** Pencil of Light:Applied Optics for Optical Engineers. *K.K. Shingijutsu Communications*
- *Applied Optics II,* 167